(19) Europäisches Patentamt
European Patent Office
Office européen des brevets

(11) **EP 2 808 688 A1**

(12) **EUROPÄISCHE PATENTANMELDUNG**

(43) Veröffentlichungstag:
**03.12.2014 Patentblatt 2014/49**

(21) Anmeldenummer: **14171234.9**

(22) Anmeldetag: **21.02.2005**

(51) Int Cl.:
*G01R 31/08* (2006.01)   *G01R 31/11* (2006.01)
*G01R 27/26* (2006.01)   *G01R 27/16* (2006.01)
*H02H 3/00* (2006.01)   *H02H 9/08* (2006.01)

(84) Benannte Vertragsstaaten:
**AT BE BG CH CY CZ DE DK EE ES FI FR GB GR HU IE IS IT LI LT LU MC NL PL PT RO SE SI SK TR**

(62) Dokumentnummer(n) der früheren Anmeldung(en) nach Art. 76 EPÜ:
**05101276.3 / 1 693 679**

(71) Anmelder: **Adaptive Regelsysteme Gesellschaft mbH**
**5020 Salzburg (AT)**

(72) Erfinder: **Leikermoser, Albert**
**5020 Salzburg (AT)**

(74) Vertreter: **Patentanwälte Pinter & Weiss OG**
**Prinz-Eugen-Straße 70**
**1040 Wien (AT)**

Bemerkungen:
Diese Anmeldung ist am 05.06.2014 als Teilanmeldung zu der unter INID-Code 62 erwähnten Anmeldung eingereicht worden.

(54) **Verfahren zur Bestimmung eines Parameters eines elektrischen Netzes**

(57) Zur Ortung von Erdfehlern, zur Erkennung von Schalthandlungen oder zur Abstimmung einer Erdschlusslöschspule ist die Kenntnis wichtiger Parameter eines elektrisches Netzes oder eines Leitungsabschnitts bzw. -abzweigs davon erforderlich. Bei hochohmigen Erdfehlern oder bei stark verstimmter Erdschlusslöschspule lassen sich diese Parameter numerisch nur beschränkt bzw. mit einiger Ungenauigkeit bestimmen, sodass diese Verfahren bei solchen Bedingungen scheitern können. Die vorliegende Erfindung zeigt nun ein Verfahren und eine zugehörige Vorrichtung zur Bestimmung der Parameter des Netzes, das sich durch besondere Robustheit und Zuverlässigkeit auch unter solchen Bedingungen auszeichnet, indem ein Injektionssignal, das ein Frequenzspektrum beinhaltet in das Nullsystem eingespeist wird und die Parameter bezüglich des eingespeisten Frequenzspektrums bestimmt werden.

Fig. 1

EP 2 808 688 A1

**Beschreibung**

Die gegenständliche Erfindung betrifft ein Verfahren und eine zugehörige Vorrichtung zur Bestimmung mindestens eines Parameters des Nullsystems eines elektrischen Versorgungsnetzes, vorzugsweise mit induktiv oder über ohmschen Widerstand geerdetem oder isoliertem Sternpunkt, und/oder eines Parameters eines Leitungsabschnittes bzw. Leitungsabzweiges des Versorgungsnetzes, insbesondere die Nulladmittanz $Y_0$ bzw. Y, die Phasensumme der Leitwerte der ohmschen Ableitungen $G_0$ bzw. g, die Phasensumme der Ableitkapazitäten $C_0$ bzw. C und/oder die Resonanzkreisfrequenz $\omega_{res}$ des Nullsystems des Netzes, wobei in den Netzsternpunkt oder in das Nullsystem des elektrischen Netzes zumindest zeitweise ein Injektionssignal eingespeist wird.

Wie aus der Literatur bekannt, führen mittel- bis niederohmige Erdfehler im sternpunktkompensierten Netz zu einem starken Anstieg der Amplitude des netzfrequenten Anteils der Verlagerungsspannung. Diese Tatsache wird üblicherweise dazu benützt, das Vorhandensein von Erdfehlern zu erkennen. Bei höher- bis hochohmigen Erdfehlern, im Bereich von einigen zehn Kiloohm aufwärts, wie sie zum Beispiel durch das Berühren einer Phasenleitung mit dem Ast eines Baumes entstehen können, liegen die Fehlerströme größenmäßig im Bereich der Unsymmetrieströme des Netzes. Dies kann dazu führen, dass die Amplitude des netzfrequenten Anteiles der Verlagerungsspannung beim Eintritt von derartig hochohmigen Erdfehlern sogar sinkt, anstatt, wie dies bei niederohmigeren Erdfehlern der Fall ist, anzusteigen. Zusätzlich ist auch festzustellen, dass übliche Fehlererkennungseinrichtungen in sternpunktkompensierten Netzen, wie z.B. ein Schutzrelais, aufgrund der Kleinheit der Messsignale bei hochohmigen Erdfehlern erfahrungsgemäß unsicher funktionieren, sodass in solchen Situationen auf diesem Wege keine zuverlässige Information über das Vorliegen eines Erdfehlers im Netz abgeleitet werden kann. Ferner ist zu bedenken, dass der netzfrequente Anteil der Verlagerungsspannung allein schon wegen der schwankenden Unsymmetrieströme ebenfalls zeitlichen Änderungen unterliegt. Zusätzlich ist zu berücksichtigen, dass sich die ohmschen Ableitungen des Netzes aufgrund von klimatischen Veränderungen ebenfalls stark ändern können. Also bedarf es neuer Methoden zur Erkennung der Fehlerhaftigkeit des sternpunktkompensierten Netzes speziell im Zusammenhang mit hochohmigen Erdfehlern.

Zur Reduktion der Fehlerströme beim Auftreten von Erdfehlern in elektrischen Verteilnetzen wird der Sternpunkt des Speisetransformators vorzugsweise induktiv geerdet, das Netz also sternpunktkompensiert betrieben. Die Induktivität dieser, zwischen dem Sternpunkt des Speisetransformators und dem Erdpotential angeordneten, Erdschlusslöschspule ist den unterschiedlichen Netzkonfigurationen jeweils nach einer Änderung der Netztopologie neu anzupassen (abzustimmen), wofür es eine Reihe von bekannten Verfahren gibt.

In der EP 235 145 B1 wird ein Verfahren zur Überwachung und Bestimmung des Dämpfungs-Unsymmetrie- und Verstimmungsgrades, also der für die Abstimmung der Erdschlusslöschspule notwendigen Parameter, beschrieben, bei dem in regelmäßigen Zeitabständen oder aufgrund einer Änderung der Sternpunkt-Erdspannung ein Reaktanzkomplement zwischen Sternpunkt und Erde geschaltet wird. Dabei wird die Sternpunkt-Erdspannung vor und nach dem Schalten des Reaktanzkomplementes in Betrag und Phase bezüglich einem Referenzsignal ermittelt und der durch die beiden Messwerte und dem Koordinatenursprung definierte Ortskreis der Sternpunkt-Erdspannung als Funktion der Verstimmung bestimmt. Daraus werden dann die obengenannten Parameter und somit auch die aktuelle Verstimmung der Erdschlusslöschspule und gegebenenfalls deren notwendige Korrektur berechnet. Im Fall einer stark verstimmten Erdschlusslöschspule kann die Sternpunkt-Erdspannung Une sowohl vor und auch nach der Zuschaltung des Reaktanzkomplements sehr kleine Werte annehmen, sodass deren Messung gewissen Ungenauigkeiten bzw. Messfehlern aufgrund von Fremdinduktionen auf den Messsignalleitungen oder Signalrauschen unterliegen kann. Aufgrund der numerischen Konditionierung des Verfahrens können sich dann bei der Durchführung erhebliche Fehlerverstärkungen bezüglich der Messfehler ergeben, die letztlich die Parameterbestimmung und den Abstimmvorgang der Erdschlusslöschspule maßgeblich beeinflussen können.

Eine weitere Methode zur Bestimmung von Abstimmung und Verstimmungsgrad der Kompensation eines elektrischen Versorgungsnetzes wird in der EP 595 677 A1 beschrieben. Bei diesem Verfahren wird ein netzfrequentes Hilfssignal ins Nullsystem des Netzes eingespeist und die Sternpunkt-Erdspannung vor und während der Einspeisung sowie der Injektionsstrom in Betrag und Phase bezüglich einem Referenzsignal gemessen. Aus den Messwerten der Änderung der Sternpunkt-Erdspannung und dem Injektionsstromsignal kann dann die Impedanz des Nullsystems des Gesamtnetzes und daraus die aktuelle Verstimmung sowie gegebenenfalls deren durchzuführende Korrektur ermittelt werden. Bei Netzzuständen mit einer stark verstimmten Erdschlusslöschspule kann die Sternpunkt-Erdspannung $U_{ne}$ bzw. deren Änderung aufgrund der Injektion ins Nullsystem auch bei der Anwendung dieser Methode sehr kleine Werte annehmen, sodass deren Messung gewissen Ungenauigkeiten bzw. Messfehlern aufgrund von Fremdinduktionen auf den Messsignalleitungen oder Signalrauschen unterliegen kann. Aufgrund der numerischen Konditionierung können auch bei der Durchführung dieses Verfahrens erhebliche Fehlerverstärkungen aufgrund der Messfehler auftreten, die letztlich die Parameterbestimmung und den Abstimmvorgang der Erdschlusslöschspule erheblich beeinflussen können. Durch die Erhöhung des Injektionsstromes kann die durch das Injektionssignal verursachte Änderung der Sternpunkt-Erdspannung vergrößert werden. Diese Maßnahme verbessert die numerische Konditionierung des Verfahrens. Sie wird jedoch durch technische und kommerzielle Kriterien in gewisser Weise begrenzt.

Aus der WO 2004/003578 A1 kann wiederum ein Verfahren entnommen werden, bei dem ein Hilfssignal mit einer Frequenz ungleich der Netzfrequenz in das Nullsystem des elektrischen Netzes eingespeist wird und mittels FFT Algorithmen aus dem Nullstrom und der Verlagerungsspannung bezüglich der Einspeisefrequenz Parameter des elektrischen Netzes ermittelt werden, die z.B. für die Abstimmung der Löschspule verwendet werden können. Die genaue Bestimmung der Spektralanteile mittels FFT Algorithmen benötigt jedoch zur Vermeidung von spektralen Leckeffekten einen stationären Systemzustand, der sich aufgrund des langsamen Einschwingens zufolge der geringen Netzdämpfung aber erst nach langen Wartezeiten einstellt. Außerdem ist zum Zeitpunkt der Injektion des Hilfssignals die Resonanzfrequenz noch nicht bekannt, wodurch unter Umständen Hilfssignale mit großen Signalamplituden notwendig wären, oder ein mehrfaches Wiederholen von Injektionszyklen mit unterschiedlichen Frequenzen notwendig wäre.

Aus der WO 02/15355 A2 ist ein Verfahren zur Erkennung und Ortung von Erdfehlern bekannt, bei dem ein Hilfssignal mit Netzfrequenz eingespeist wird, sodass die Verlagerungsspannung bei Netzfrequenz kompensiert wird. In diesem Zustand kann ein weiteres Hilfssignal mit einer Frequenz ungleich der Netzfrequenz eingespeist werden, und aus den gemessenen Größen bezüglich der Einspeisefrequenz Netzparameter bestimmt werden. Es ist auch beschrieben, mehrere Hilfssignale mit unterschiedlichen Frequenzen ungleich der Netzfrequenz einzuspeisen und aus den daraus ermittelten Netzparametern eine bestmögliche Approximation der Netzparameter, z.B. durch Mittelwertbildung, zu bestimmen. Wenn die verschiedenen Frequenzen gleichzeitig eingespeist werden, muss aber darauf geachtet werden, dass sich die einzelnen Frequenzspektren nicht überschneiden, da nur dann die einzelnen Frequenzanteile unabhängig voneinander betrachtet werden dürfen und kein Hilfssignal Frequenzanteile einer anderen Frequenz beinhaltet und man damit mit der Wahl der Frequenzen eingeschränkt ist. Ein weiteres damit verbundenes Problem liegt darin, dass durch das Injektionsspektrum einzelne Spektralanteile auch unterschiedlich stark ausgeprägt sein werden, was wiederum zu einer unterschiedlich starken Anregung des Nullsystems und damit zu Messungen unterschiedlicher Qualität führen wird.

Aus der US 5,587,662 A geht ein Verfahren hervor, bei dem ein Leitungsparameter in Form der Leitungsimpedanz ermittelt wird, indem ein Hilfssignal mit einer Frequenz ungleich der Netzfrequenz in die Leitung eingespeist wird und Spannung und Strom bezüglich dieser Frequenz gemessen und zur Bestimmung der Leitungsparameter dividiert werden. Dabei können sukzessive auch eine Fülle verschiedener Frequenzen in die Leitung eingespeist werden, wobei aber immer nur bezüglich einer einzigen Frequenz ausgewertet wird.

Die DE 100 06 443 A1 beschreibt, dass zur Bestimmung der Leitungsimpedanz ein ganzes Frequenzspektrum eingespeist wird. Aus dem Leitungsparameter kann aber kein Parameter des Nullsystems eines Versorgungsnetzes bestimmt werden.

Die der Erfindung zugrundeliegende Aufgabe ist es daher, ein einfach umsetzbares Verfahren zu entwickeln, das selbst im Fall von Netzzuständen mit stark verstimmter Erdschlusslöschspule und/oder bei hochohmigen Erdfehlern mit geringen Injektionssignalamplituden starke Signaländerungen im Nullsystem bewirkt und damit die numerische Stabilität und Robustheit der Parameterbestimmung und somit auch des Abstimmvorganges der Erdschlusslöschspule bzw. der Erkennung von Erdfehlern deutlich erhöht werden kann.

Diese Aufgabe wird für das Verfahren und die Vorrichtung erfindungsgemäß gelöst, indem mit dem Injektionssignal ein Frequenzspektrum eingespeist wird, wobei das Frequenzspektrum des Injektionssignals den Bereich zwischen einer wählbaren minimalen Frequenz $f_{min}$ und einer wählbaren maximalen Frequenz $f_{max}$ im Wesentlichen lückenlos abdeckt und im Frequenzspektrum die Resonanzfrequenz $\omega_{res}$ des Nullsystems des elektrischen Versorgungsnetzes enthalten ist und zumindest ein Parameter aus einem funktionalen Zusammenhang in Form einer Gleichung mit dem Parameter und den Größen Nullstrom $i_0$ und Injektionssignal $i_{inj}$ oder Verlagerungsspannung $U_{ne}$ und Injektionssignal $i_{inj}$ bezüglich des eingespeisten Frequenzspektrums durch ein Verfahren im Zeitbereich oder Frequenzbereich ermittelt wird. Dieses Verfahren bewertet die zugrunde liegenden Messgrößen damit nicht nur bezüglich einer einzigen diskreten Frequenz, oder einiger diskreter Frequenzen, sondern vorzugsweise bezüglich der Gesamtheit der Frequenzanteile des Injektionsspektrums, da die Parameter bezüglich des gesamten Frequenzspektrums bestimmt werden. Daraus resultiert eine Erhöhung der Robustheit und Reproduzierbarkeit bei der Parametebestimmung, was letztendlich zu einer Verbesserung der Gesamtperformance der Regeleinrichtung führt.

Die Robustheit wird noch weiter erhöht, wenn sichergestellt wird, dass im eingespeisten Frequenzspektrum die Resonanzfrequenz $\omega_{res}$ des Nullsystems des elektrischen Netzes enthalten ist. Wird also ein Signal das die Resonanzfrequenz beinhaltet in geeigneter Weise in das Nullsystem des Gesamtnetzes eingespeist, so ergibt sich aufgrund der Anregung des Systems an einer Polstelle eine starke Erhöhung der Sternpunkt-Erdspannung $U_{ne}$ im Vergleich zur Anregung mit anderen von der Resonanzfrequenz unterschiedlichen Frequenzen. Dadurch können bei resonanzfrequenter Anregung auch mit kleinen Amplituden des Injektionssignals aufgrund der Polanregung hohe Signalamplituden der Sternpunkt-Erdspannung $U_{ne}$ und damit auch des durch die Löschspule zurückfließenden Nullstromes $i_0$ erzeugt werden, während die sich von der Resonanzfrequenz unterscheidenden Spektralanteile des Injektionssignals nur kleine Amplituden bezüglich der Sternpunkt-Erdspannung $U_{ne}$ und Nullstrom $i_0$ ergeben. Wegen der daraus entstehenden hohen Signalamplituden der Sternpunkt-Erdspannung $U_{ne}$ sowie des Nullstromes $i_0$ bezüglich ihrer resonanzfrequenten Signalanteile ergibt sich daraus eine gute numerische Konditionierung der anzuwendenden Verfahren zur Bestimmung der Netzparameter, was letztlich die Robustheit und numerische Stabilität des Abstimmverfahrens für die Erdschlusslöschspule, als auch von Verfahren zur Erkennung und Ortung von Erdfehlern, selbst bei stark verstimmten Netzzuständen und auch bei sehr hochohmigen Erdfehlern, im Vergleich zu anderen Methoden deutlich erhöht.

Das Frequenzspektrum kann vorteilhaft entweder dadurch erzeugt werden, indem als Injektionssignal ein Signal gewählt wird, vorzugsweise ein impulsförmiges Signal, das zwischen der minimalen Frequenz $f_{min}$ und der maximalen Frequenz $f_{max}$ von Null verschiedene Spektralanteile beinhaltet, was eine besonders einfach unzusetzende Methode darstellt.

Werden die netzfrequenten Signalanteile und jene Signalanteile, deren Frequenz einem ungeradzahlig ganzzahligem Vielfachen der Netzfrequenz entspricht, aus dem Frequenzspektrum der verarbeiteten Messgrößen herausgefiltert, oder werden diese Anteile nicht eingespeist, oder werden diese Anteile durch Subtraktion der vor dem Start des Injektionsvorganges als Funktion der Zeit gemessenen und bezüglich der Netzperiode für die Zeiten nach dem Injektionsvorgang periodisch fortgesetzten Größen von den nach dem Start des Injektionsvorganges gemessenen Größen oder durch Subtraktion der Spektralanteile der periodisch fortgesetzten Größen von den Spektralanteilen der gemessenen Größen entfernt, ergeben sich bezüglich der nicht netzfrequenten Anteile einfache funktionale Zusammenhänge, wodurch die Ermittlung der Parameter vereinfacht wird.

Als besonders einfache Verfahren zur Bestimmung der Parameter lassen sich hinlänglich bekannte und in großer Anzahl existierende Parameterschätzverfahren anwenden, bei dem z.B. das elektrische Netz und/oder ein Leitungsabschnitt bzw. Leitungsabzweig durch ein mathematisches Modell beschrieben wird, bei dem die Modellausgangsgrößen $A_{Mod}$ als Funktion der messbaren Eingangsgrößen und der zu ermittelnden Parameter beschrieben wird und daraus eine Modellfehlerfunktion als Differenz aus gemessenen Ausgangsgrößen $A_P$ und den Modellausgangsgrößen $A_{Mod}$ und eine Verlustfunktion V, beispielsweise in Form der Summe der Quadrate der Modellfehlerfunktion im gewählten Beobachtungszeitraum, ermittelt wird, die zur Bestimmung der Parameter derart optimiert wird, dass die Verlustfunktion V minimal wird. Solche Verfahren lassen sich einfach in digitaler Form auf Computern realisieren und lassen sich auch einfach in Regelungseinheiten für die Abstimmung von Löschspulen oder zur Erkennung und Ortung von Erdfehlern oder Schalthandlungen im Netz integrieren.

Die so bestimmten Parameter des elektrischen Netzes bzw. eines Leitungsabschnittes bzw.--abzweigs, insbesondere $Y_0$, Y, G, g, $C_0$, C oder $\omega_{res}$, lassen sich besonders vorteilhaft und einfach zur Erkennung und Ortung von Erdfehlern, Erkennung und Lokalisierung von Schalthandlungen im Netz und/oder zur Abstimmung einer Löschspule verwenden, wie z.B. auch in der WO 2004/003578 A1 des Anmelders beschrieben, die Teil der Offenbarung dieser Anmeldung ist.

Mit den derart bestimmten Parametern des Netzes kann die notwendige Erdschlusslöschspuleninduktivität $L_{soll}$, gegebenenfalls unter Berücksichtigung einer vom Anwender vorgegebenen Verstimmung, als Funktion der ermittelten Parameter des Nullsystems des elektrischen Netzes zur Einhaltung der Resonanzbedingung ermittelt werden und durch Vergleich mit einer momentan gegebenen Erdschlusslöschspuleninduktivität $L_{ist}$ oder durch Vergleich der ermittelten Resonanzkreisfrequenz $\omega_{res}$ mit der gewünschten Resonanzkreisfrequenz $\omega_{soll}$ einfach festgestellt werden, ob eine Neuabstimmung der Erdschlusslöschspule notwendig ist oder nicht. Die tatsächliche Abstimmung kann mit hinlänglich bekannten Methoden zur Abstimmung einer Erdschlusslöschspule durchgeführt werden.

Falls die Verlagerungsspannung $U_{ne}$ als Messgröße nicht oder nicht in ausreichender Genauigkeit zugänglich ist, kann ein Parameter des Netzes immer noch ermittelt werden, wenn mittels eines mathematischen Modells des elektrischen Netzes ein funktionaler Zusammenhang zwischen dem gemessenen Nullstrom $i_0$ des elektrischen Netzes, dem Injektionssignal und zumindest einem Parameter des Netzes hergestellt wird und daraus der oder die Parameter bestimmt werden. Das tatsächlich eingespeiste Injektionssignal ist messbar und es kann durch einen einfachen Zusammenhang, der im Wesentlichen nur von der Art der Einbringung des Injektionssignals ins Nullsystem des Netzes abhängig ist, auf das im mathematischen Modell verwendete Injektionsstromsignal rückgeschlossen werden. Durch diesen neuartigen Ansatz ist es möglich, Verfahren zur Bestimmung der Parameter eines elektrischen Netzes auch dann anzuwenden, selbst wenn die Verlagerungsspannung nicht oder nicht in ausreichender Genauigkeit bekannt oder messbar ist.

Die Erfindung wird anhand der folgenden Erläuterungen unter Bezugnahme auf die begleitenden beispielhaften und schematischen Zeichnungen Fig. 1 bis 4 näher beschrieben. In den Zeichnungen zeigt

Fig. 1 ein elektrisches Ersatzschaltbild eines sternpunktkompensierten Netzes mit einem Leitungsabschnitt bzw. Leitungsabzweig,
Fig. 2 ein vereinfachtes elektrisches Ersatzschaltbild des Nullsystems eines sternpunktkompensierten Netzes mit induktiver Sternpunkterdung,
Fig. 3 ein elektrisches Ersatzschaltbild des Nullsystems für die Erdschlusslöschspule, der Injektionseinheit und des Netzes und
Fig. 4 ein Ablaufschema zur Bestimmung der Netzparameter.

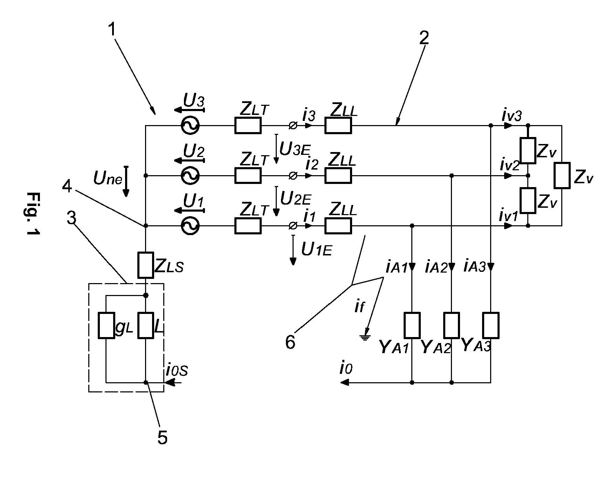

In Fig. 1 ist das bekannte elektrische Ersatzschaltbild eines Leitungsabschnittes 2 eines elektrischen Versorgungsnetzes 1 dargestellt. Zwischen dem Transformatorsternpunkt 4 und dem Erdungspunkt 5 befindet sich beispielhaft eine Löschspule 3, die durch einen ohmschen Leitwert $g_L$ und einer Induktivität L beschrieben wird. Wird das Netz widerstandsgeerdet betrieben, so wird der Erdungswiderstand durch den Leitwert $g_L$ repräsentiert, während die Induktivität L entfällt. Die Streuinduktivitäten sowie die ohmschen Widerstände der Sekundärwicklung des Speisetransformators werden durch die für alle drei Phasen als gleich groß angenommenen Längsimpedanzen $Z_{LT}$ repräsentiert. In das Netz, hier bestehend aus nur einem Leitungsabschnitt 2, werden die Phasenspannungen $U_1$, $U_2$ und $U_3$ eingespeist und es fließen die Phasenströme $i_1$, $i_2$ und $i_3$. Zwischen den drei Phasen und der Erde liegen die Phasen-Erdspannungen $U_{1E}$, $U_{2E}$ und $U_{3E}$ an.

Ein Leitungsabschnitt 2 wird, wie für den betrachteten Frequenzbereich von <150Hz zulässig, durch Leitungslängsimpedanzen $Z_{LL}$, bestehend aus einem ohmschen und einem induktiven Term, und Leitungsableitadmittanzen (bzw. Phasen-Erdadmittanzen) $Y_{A1}$, $Y_{A2}$ und $Y_{A3}$, bestehend aus einer ohmschen g und einer dazu parallelen kapazitiven Komponente C, beschrieben. Über die Leitungsableitadmittanzen $Y_{A1}$, $Y_{A2}$ und $Y_{A3}$ fließen die Ableitströme $i_{A1}$, $i_{A2}$ und $i_{A3}$. Die Ableitströme $i_{A1}$, $i_{A2}$ und $i_{A3}$ fließen als Nullstrom $i_0$ dieses Leitungsabschnittes über die Löschspule 3 zum Transformatorsternpunkt 4 zurück. Am Erdungspunkt der Löschspule 3 vereinigen sich die Nullströme $i_0$ aller vorhandenen Leitungsabschnitte 2 zur Summe der Nullströme $i_{0S}$. Verbraucherseitig, repräsentiert durch Verbraucherimpedanzen $Z_V$, fließen die Verbraucherströme $i_{V1}$, $i_{V2}$ und $i_{V3}$.

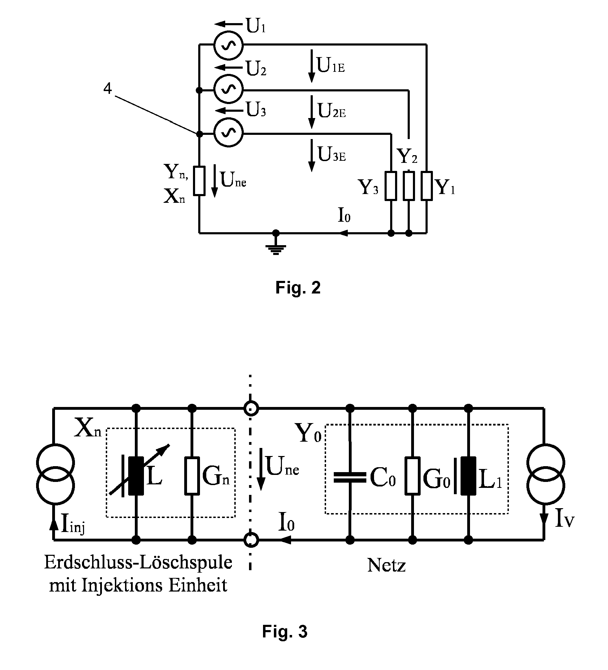

Um die Wirkungsweise und die Vorteile der Injektion eines Frequenzspektrums ins Nullsystem des Netzes darlegen zu können, werden einige Zusammenhänge für ein vereinfachtes Modell eines sternpunktkompensierten Netzes, wie in Fig. 2 dargestellt, hergeleitet. Dabei bleiben die Leitungslängsimpedanzen $Z_{LL}$, die Streuimpedanzen des Transformators $Z_{LT}$, die von den Nullströmen durchflossenen Erdimpedanzen und die Leitungskoppelkapazitäten zwischen den einzelnen Phasen aus Gründen der Übersichtlichkeit und ihres geringen Einflusses im Nullsystem unberücksichtigt. Sie können jedoch ohne Beeinträchtigung der Methodik dieses Verfahrens mit berücksichtigt werden. Dies führt lediglich zu einer Erhöhung der Ordnung der Modellgleichungen. Da eventuell im Netz vorhandene zusätzliche Erdschlusslöschspulen nur im Nullsystem eine Auswirkung zeigen, werden diese erst später bei den Gleichungen für die Zusammenhänge im Nullsystem des Gesamtnetzes eingeführt.

Dieses Ersatzschaltbild wird zur Herleitung von für das erfindungsgemäße Verfahren wichtigen Beziehungen verwendet.

Zu den folgenden Erläuterungen sei vorab angemerkt, dass sich die nachfolgenden Formeln, wenn nicht anders angemerkt, auf die Laplacetransformierten der jeweiligen elektrischen Größen beziehen, die vorkommenden elektrischen Größen zwecks Vereinfachung der Schreibweise jedoch nicht explizit als Funktion der komplexen Frequenzvariablen $s$ geschrieben werden, also wird beispielsweise $U_{ne}(s)$ mit $U_{ne}$ bezeichnet.

Die Phasen-Erdadmittanzen $Y_1$, $Y_2$, $Y_3$ einzelner Leitungsabschnitte bzw. -abzweige lassen sich für den betrachteten Frequenzbereich bis ca. 150 Hz in guter Näherung durch die Parallelschaltung einer Abschnittkapazität mit einem Abschnittableitwiderstand beschreiben. Die drei Phasen-Erdadmittanzen $Y_1$, $Y_2$, $Y_3$ des Gesamtnetzes ergeben sich durch Nichtberücksichtigung der Leitungslängsimpedanzen als Parallelschaltung der einzelnen Leitungsabschnitte und somit durch phasenbezogene Summation obiger Abschnittsadmittanzen über alle Teilabschnitte bzw. -abzweige des Gesamtnetzes. Wenn man berücksichtigt, dass sich die drei Phasen-Erdspannungen $U_{1E}$, $U_{2E}$ und $U_{3E}$ durch Summation der zugehörigen Phasenspannungen $U_1$, $U_2$ und $U_3$ mit der Sternpunkt-Erdspannung (oder Verlagerungsspannung) $U_{ne}$ ergeben und ferner bedenkt, dass die Summe der drei Phasenspannungen $\Delta U$ zwar theoretisch null sein muss, in der Praxis aber aufgrund nicht perfekter magnetischer Verkoppelungen der Transformatorwicklungen im Zusammenhang mit Laststromeinflüssen und/oder durch Fehlen einer Dreieckswicklung im Transformator einen manchmal nicht unerheblichen Wert annehmen kann, ergibt sich unter Berücksichtigung der angeführten Definitionen für den, über das Erdreich und die Erdschlusslöschspule 3 in den Sternpunkt 4 zurück fließenden, Nullstrom $i_0$ als Funktion der Sternpunkt-Erdspannung $U_{ne}$ nach kurzer Herleitung der bekannte Zusammenhang:

$$i_0 = U_{ne} \cdot Y_0 + i_v + \left[ i_f \right],$$

mit der Nulladmittanz, bzw. gleichwertig auch als Erdadmittanz bezeichnet, $Y_0 = (Y_1 + Y_2 + Y_3)$ und dem Unsymmetriestrom,

bzw. *Verlagerungsstrom,* $i_v = \Delta U \cdot \overline{Y} + \sum_{n=1}^{3} U_n \cdot \Delta Y_n$ , mit der Asymmetrie der Phasenspannungen $\Delta U = U_1 + U_2 + U_3$,

dem Mittelwert der drei Phasen-Erdadmittanzen $\overline{Y} = Y_0/3$ und der Abweichung der Phasen-Erdadmittanzen der Phase (n) vom Mittelwert $\Delta Y_n = Y_n - \overline{Y}$, und gegebenenfalls dem im Fehlerfall vorhandenen Fehlerstrom $i_f$

Der Term $Y_0$ repräsentiert die Phasensumme der Ableitadmittanzen $Y_0 = (Y_1 + Y_2 + Y_3)$ der drei Phasen, wobei sich die einzelnen Ableitadmittanzen aus der Parallelschaltung eines resistiven g und eines kapazitiven Termes C zusammensetzen. Für den (n)-ten Leitungsabschnitt bzw. -abzweig wird die Nulladmittanz $Y_0$ mit Y(n) bezeichnet.

Die obige Gleichung für den Nullstrom $i_0$ liefert die wichtige Erkenntnis, dass sich der Nullstrom $i_0$ des Gesamtnetzes aus der Summe von einem, vom Produkt der Sternpunkt-Erdspannung $U_{ne}$ mit der Nulladmittanz $Y_0$ abhängigen Term und dem Unsymmetriestrom $i_v$ ergibt. Dieser Unsymmetriestrom hängt wiederum einerseits von der Asymmetrie der Phasenspannungen $\Delta U$ sowie von den Unsymmetrien der drei Phasen-Erdadmittanzen $\Delta Y_n$ ab, ist jedoch unabhängig vom Nullsystem und somit von der Sternpunkt-Erdspannung $U_{ne}$ und kann daher in einem Ersatzschaltbild für das Nullsystem durch eine Stromquelle repräsentiert werden.

Betrachtet man nun die obige Beziehung für den Unsymmetriestrom $i_v$ spektral, also $i_v(j\overline{\omega})$, so kann aufgrund der Fourierreihenzerlegung der Phasenspannungen und der Erkenntnis, dass sich der Unsymmetriestrom $i_v(j\overline{\omega})$ als Linearkombination der drei Phasenspannungen ergibt, direkt daraus gefolgert werden, dass der Spektralanteil des Unsymmetriestromes $i_v(j\overline{\omega})$ in Analogie zu den drei Phasenspannungen für Kreisfrequenzen ungleich der Netzkreisfrequenz $\omega_N$ und deren ganzzahlig ungeradzahligen Vielfachen Null sein muss, im elektrischen Ersatzschaltbild des Nullsystems nach Fig.3 also unberücksichtigt bleiben kann und daher für diese Kreisfrequenzen die Stromquelle des Unsymmetriestromes $i_v(j\overline{\omega})$ aus dem Ersatzschaltbild zu eliminieren ist. Daher werden die Spektralanteile der Sternpunkt-Erdspannung $U_{ne}(j\overline{\omega})$ und des Nullstromes $i_0(j\overline{\omega})$ bezüglich dieser Kreisfrequenzen ausschließlich von der Injektionsstromquelle verursacht.

Werden nun die netzfrequenten Grundwellenanteile sowie jene Oberwellenanteile, deren Frequenzen einem ganzzahlig ungeradzahligem Vielfachen der Netzfrequenz entsprechen, mit analogen Filtern aus den Messgrößen von $U_{ne}(t)$, $i_{inj}(t)$ und $i_0(t)$, oder in digitaler Weise aus den abgetasteten und digitalisierten Messgrößen von $U_{ne}(t)$, $i_{inj}(t)$ und $i_0(t)$, durch Verwendung geeigneter Sperrfilter, also Filtern, die genau obige Frequenzanteile aus den genannten Signalen herausfiltern, vorgefiltert, so ergibt sich unter der Voraussetzung, dass diese Filterung kontinuierlich durchgeführt wird oder mit der Injektion erst lange nach dem Einschwingen der Sperrfilterkette begonnen wird, der folgende Zusammenhang (der Index F bezeichnet im Nachfolgenden derart gefilterte Größen)

$$i_0^F(s) - U_{ne}^F(s).Y_0(s) = 0 \, ,$$

$$Y_0(s) = G_0 + s.C_0 + \frac{1}{s.L_1}$$

mit der Laplace-Transformierten des gefilterten Nullstromsignals $i_0^F(s)$ und der Laplace-Transformierten der Netznulladmittanz $Y_0(s)$ mit zusätzlicher Erdschlusslöschspule $L_1$.

Diese Sperrfilter besitzen jedoch die unangenehme Eigenschaft, dass speziell bei exakter Abstimmung der Erdschlusslöschspule, also bei weitgehend der Netzfrequenz entsprechenden Resonanzfrequenzen des kompensierten Netzes, gerade diese starke, ungefähr netzfrequente, Signalanregung in den auszuwertenden Messgrößen aufgrund der Filtercharakteristik (Unterdrückung netzfrequenter Signalanteile) wieder unterdrückt wird. Betrachtet man das Ersatzschaltbild für den Injektionsvorgang nach Fig. 3, dann ist klar ersichtlich, dass die Schaltung von zwei Stromquellen, nämlich $i_{inj}(t)$ und $i_v(t)$, gespeist wird. Da die Schaltungselemente als linear angenommen werden können, kann in bekannter Weise das Superpositionsprinzip zur Anwendung gebracht werden. Das bedeutet, dass sich die Sternpunkt-Erd-spannung $U_{ne}(t)$ als Summe des vom Unsymmetriestrom $i_v(t)$ verursachten Signalanteiles und des vom Injektionsstrom $i_{inj}(t)$ verursachten Signalanteiles darstellen lässt.

Der vom Unsymmetriestrom $i_v(t)$ verursachte Signalanteil an der Sternpunkt-Erdspannung $U_{ne}(t)$ kann aber vor dem Start des Injektionsvorganges als Funktion der Zeit gemessen und aufgrund seiner oben genannten Eigenschaften für die Zeitpunkte nach dem Injektionsstart bezogen auf die Netzfrequenz periodisch fortgesetzt werden, da er nur einen netzfrequenten Anteil und bezüglich der Netzfrequenz ganzzahlig ungeradzahlige Vielfache als Oberwellenanteile enthalten kann und sich während der kurzen Injektionszeit kaum ändert. Subtrahiert man nun für die Zeitpunkte nach dem Injektionsbeginn bei t=0 von der gemessenen Sternpunkt-Erdspannung $U_{ne}(t)$ den vor dem Start des Injektionsvorganges als Funktion der Zeit, also für t<0, gemessenen und bezüglich der Netzperiode für die Zeiten t≥0 periodisch fortgesetzten Signalanteil der Sternpunkt-Erdspannung $U_{ne}(t)$, so erhält man aufgrund des Überlagerungsprinzips direkt einsichtig den vom Injektionsstrom $i_{inj}(t)$ verursachten Signalanteil an der Sternpunkt-Erdspannung $U_{ne}(t)$. Dieser wird

aus Gründen der Übersichtlichkeit und der Gleichwertigkeit mit der Filtermethode wieder mit $U_{ne}^{F}(t)$ bezeichnet.

In ganz analoger Weise kann für den Nullstrom $i_0(t)$ vorgegangen werden. Subtrahiert man für die Zeitpunkte nach dem Injektionsbeginn bei t=0 vom gemessenen Nullstrom $i_0(t)$ den vor dem Start des Injektionsvorganges als Funktion der Zeit, also für t<0, gemessenen und bezüglich der Netzperiode für die Zeiten t≥0 periodisch fortgesetzten Signalanteil des Nullstromes $i_0(t)$, so erhält man aufgrund des Überlagerungsprinzips den vom Injektionsstrom $i_{inj}(t)$ verursachten Signalanteil am Nullstrom $i_0(t)$. Dieser wird aus Gründen der Übersichtlichkeit und der Gleichwertigkeit mit der Filtermethode wieder mit $I_0^{F}(t)$ bezeichnet.

Damit hat man eine Alternative zur oben beschriebenen Filterung der Messgrößen durch Sperrfilter, die die erwähnte unangenehme Eigenschaft nicht aufweist. Aufgrund der Gleichwertigkeit der dargestellten Überlagerungsmethode mit der Sperrfiltermethode wird im folgenden Text nicht mehr unterschieden, auf welche Weise die so genannten "gefilterten" Größen $I_0^{F}(t)$ und $U_{ne}^{F}(t)$ erzeugt werden.

Für das gefilterte Injektionsstromsignal $I_{inj}^{F}(t)$ gilt, dass es bei Anwendung der Überlagerungsmethode für die Zeitpunkte t≥0 dem gemessenen Injektionsstromsignal $i_{inj}(t)$ gleichzusetzen ist, da der Injektionsvorgang bei t=0 gestartet wird und daher das Injektionsstromsignal für die Zeitpunkte t<0 gleich null sein muss. Deshalb ist auch dessen periodische Fortsetzung für die Zeitpunkte t≥0 gleich Null.

Unabhängig von der Art der Einbringung eines Injektionssignals ins Nullsystem des elektrischen Netzes kann das Ersatzschaltbild für die Erdschlusslöschspule und der Injektionseinheit in guter Näherung durch die Erdschlusslöschspulenimpedanz $X_n$, in Form einer Parallelschaltung der Erdschlusslöschspuleninduktivität L mit einem, die Eisenverluste der Erdschlusslöschspule beschreibenden und durch dessen Konduktanz $G_n$ repräsentierten, Widerstand, und mit der Stromquelle für das Injektionssignal $I_{inj}$ dargestellt werden, wie in Fig. 3 gezeigt. Die Berücksichtigung der Kupferverluste der Erdschlusslöschspule kann durch das Einfügen eines ohmschen Widerstandes in Serie mit der Induktivität L in einfacher Weise erfolgen, wodurch sich lediglich die Ordnung der Modellgleichungen erhöhen würde, aber die Anwendbarkeit des Verfahrens in keiner Weise eingeschränkt werden würde. Die Nulladmittanz $Y_0$ des Netzes kann ohne zusätzliche Erdschlusslöschspulen im Netz für den betrachteten Frequenzbereich in guter Näherung durch deren kapazitiven Anteil $C_0$ parallel mit der Nullkonduktanz $G_0$ angenommen werden. Die Induktivität $L_1$ repräsentiert eventuell im Netz vorhandene zusätzliche Erdschlusslöschspulen. Deren Eisenverluste werden in $G_0$ mit berücksichtigt. Die Stromquelle $I_v$ beschreibt die Unsymmetrieströme des Gesamtnetzes entsprechend der obigen Gleichung.

Über grundlegende Beziehungen in diesem Ersatzschaltbild erhält man die bekannte Resonanzbedingung für die Resonanzkreisfrequenz $\omega_{res}$ des Nullsystems des Netzes mit

$$\omega_{res} = \sqrt{1/(L' \cdot C_0)}, \text{ mit } L' = \frac{L_1 \cdot L}{L_1 + L}.$$

Sind nun zur ausreichend genauen Messung der beiden Größen $U_{ne}(t)$ und $i_0(t)$ geeignete Messeinrichtungen verfügbar, so können deren Messwerte bezüglich eines eingespeisten Frequenzspektrums zur Durchführung eines Verfahrens zur Bestimmung der Netzparameter $G_0$, $C_0$ und $L_1$, z.B. hinlänglich bekannte Parameterschätzverfahren, verwendet werden, wie weiter unten beschrieben.

Ferner können die obigen Gleichungen in äquivalenter Weise auch als grundlegende Gleichungen zur Entwicklung eines Verfahrens zur Bestimmung der Parameter des Nullsystems von Leitungsabschnitten oder Leitungsabzweigen verwendet werden, wenn die Laplace-Transformierte des gefilterten Nullstrommesssignales des überwachten Leitungsabschnittes oder Leitungsabzweiges und die Laplace-Transformierte des gefilterten Sternpunkt-Erdspannungsmesssignals verwendet wird. Die ermittelten Parameter entsprechen dann den Nullsystemparametern des überwachten Leitungsabschnittes oder Leitungsabzweiges. Die derart ermittelten Abschnittsparameter könnten z.B. zur Erkennung und Ortung von Erdfehlern verwendet werden.

Üblicherweise bereitet die Messung des Nullstromes $i_0(t)$ keine Probleme, da dazu geeignete Stromwandler in der Mehrzahl der Anwendungen vorhanden sind. Anders verhält es sich jedoch bei der Messung der Sternpunkt-Erdspannung $U_{ne}$, sofern nicht eine direkte Messeinrichtung zur Messung der Sternpunkt-Erdspannung oder alternativ drei Spannungswandler zur Messung der drei Phasenerdspannungen mit nachfolgender Verschaltung der Sekundärwicklungen im offenen Dreieck anlagenseitig vorhanden sind. Die üblicherweise bei Erdschlusslöschspulen verfügbaren Messwicklungen für die Messung der Sternpunkt-Erdspannung sind für diesen Zweck kaum geeignet, da einerseits magnetische Einflüsse innerhalb der Erdschlusslöschspule die Messung beeinträchtigen und andererseits die Streuinduktivitäten und Kupferwiderstände der Sternwicklung des Transformators zusammen mit den Phasenströmen Spannungsabfälle im Nullsystem verursachen, die real im Netz vorhanden sind, jedoch von dieser Messwicklung nicht mit gemessen werden.

Durch die Verwendung des, aufgrund eines Injektionsmodells aus einem messbaren (äußeren) Injektionssignal rekonstruierten, modellhaften Injektionsstromsignales $i_{inj}(t)$ des Ersatzschaltbildes nach Fig.3 und der Messwerte des Nullstromes, also des Löschspulenstromes, $i_0(t)$ als Eingangsgrößen ergibt sich unter Berücksichtigung der oben beschriebenen Zusammenhänge eine alternative Möglichkeit für die Durchführung eines Verfahrens zur Bestimmung der Netzparameter, wie z.B. $G_0$, $C_0$ und $L_1$. Aus grundlegenden Beziehungen am Ersatzschaltbild nach Fig. 3 und unter Verwendung der Erdschlusslöschspulenimpedanz

$$X_n(s) = \frac{L.s}{1 + (G_n.L).s}$$

ergibt sich die Beziehung

$$[i_0^F(s).G_1(s)] - [i_{inj}^F(s) - i_0^F(s)].[(\frac{L}{L_1}).\frac{1}{s} + (G_0.L) + (C_0.L).s] = 0$$

$$\text{mit } G_1(s) = \frac{1}{s} + (G_n L).$$

Damit hat man einen Zusammenhang zwischen den Größen Injektionsstromsignal $i_{inj}(t)$ und Nullstrom $i_0(t)$ und den Netzparametern $G_0$, $C_0$ und $L_1$. Diese Beziehung kann wiederum zur Bestimmung der Netzparameter $G_0$, $C_0$ und $L_1$, z.B. mittels hinlänglich bekannter Bestapproximationsverfahren, wie z.B. mittels dem bekannten RLS Algorithmus, verwendet werden.

Der Nullstrom $i_0(t)$ kann dabei mittels eines Stromwandlers oder einer anderen geeigneten Messeinrichtung direkt als der in der Erdschlusslöschspule fließende Strom gemessen werden, da nach Fig.1 bzw. 2 der Nullstrom $i_0(t)$ über die Erdschlusslöschspule zum Wicklungssternpunkt des Transformators zurück fließen muss. Schwieriger gestaltet sich die Bestimmung des durch eine Stromquelle repräsentierten Injektionsstromes $i_{inj}(t)$, da dieser Strom, der im Injektionsmodell durch Zweipolumformung entsteht, eine Modellgröße darstellt und daher nicht direkt messbar ist. Es lässt sich aber zeigen, dass unabhängig von der Art der Einbringung eines Injektionssignals ins Nullsystem des Netzes, also entweder in Form einer in Serie zur Erdschlusslöschspule geschalteten Spannungsquelle oder durch parallel zur Erdschlusslöschspule erfolgende Einspeisung mit einer Stromquelle, ein funktionaler, in manchen Fällen nahezu proportionaler, Zusammenhang zwischen dem tatsächlichen und daher messbaren Injektionssignal und dem modellartigen Injektionsstrom $i_{inj}(t)$ hergestellt werden kann. Daher kann der Injektionsstrom $i_{inj}(t)$ des Injektionsmodells immer aus einer Messgröße des zugänglichen und daher tatsächlich messbaren Injektionssignals unter Verwendung der durch die Art der Injektion bedingten Zusammenhänge berechnet werden. Im Sinne dieser Erfindung können die beiden Größen, nämlich die Modellgröße Injektionsstrom $i_{inj}(t)$ und die messbare Größe Injektionssignal, daher als gleichwertige Größen aufgefasst werden.

Dieser oben beschriebene Zusammenhang zwischen dem Injektionssignal $i_{inj}$ und dem Nullstrom, ohne die Verlagerungsspannung $U_{ne}$, zur Ermittlung der Parameter eines elektrischen Netzes oder eines Abschnitts bzw. Abzweigs davon, ist als solches ebenfalls als erfinderisch anzusehen, da es damit möglich ist, eine nur schwer oder nicht messbare Größe, wie z.B. die Verlagerungsspannung $U_{ne}$, aus dem funktionalen Zusammenhang zu eliminieren bzw. durch eine messbare Größe, wie eben das Injektionssignal $i_{inj}$, zu ersetzen.

Es ist aber selbstverständlich auch möglich, aus dem Modell einen Zusammenhang zwischen dem aus einen messbaren (äußeren) Injektionssignal rekonstruierten Injektionsstromsignal $i_{inj}(t)$ und den Messwerten der Sternpunkt-Erdspannung $U_{ne}(t)$ herzustellen und zur Bestimmung der Netzparameter, wie z.B. $G_0$ $C_0$ und $L_1$, zu verwenden. Durch einfache Umformungen des funktionalen Zusammenhangs zwischen den gefilterten Größen des Injektionsstromsignals und der Sternpunkt-Erdspannung, erhält man letztendlich den gewünschten Zusammenhang mit

$$I_{inj}^{F}(s) - U_{ne}^{F}(s) \cdot G - U_{ne}^{F}(s) \cdot s \cdot C_0 - \left[\frac{U_{ne}^{F}(s)}{s}\right] \cdot \frac{1}{L'} = 0$$

und

$$G = G_0 + G_n \quad \text{und} \quad L' = \frac{L_1 . L}{L_1 + L} \; .$$

Generell kann also gesagt werden, dass sich die Parameter des Gesamtnetzes immer aus einem funktionalen Zusammenhang zwischen zwei der messbaren Größen, nämlich Nullstrom $i_0$, Sternpunkt-Erdspannung $U_{ne}$ und Injektionsstromsignal $i_{inj}$, bestimmen lassen.

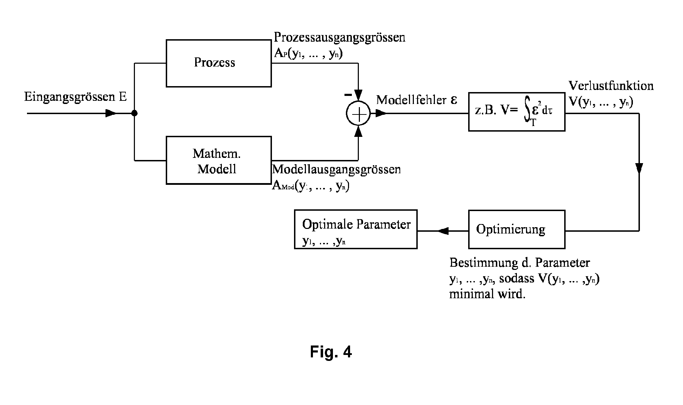

Ein mögliches Schätzverfahren zur Bestimmung der Netzparameter wird im Nachfolgenden unter Bezugnahme auf das das Verfahren verdeutlichende Blockschaltbild nach Fig. 4 skizziert. Aufgrund der, die Dynamik des Prozesses beschreibenden, Modellgleichungen ist es wie oben erläutert möglich, die Prozessausgangsgrößen A des Modells als Funktion der messbaren Prozesseingangsgrößen E und der unbekannten inneren Prozessparameter y zu beschreiben. Bildet man nun die Differenz von diesen, mathematisch als Funktion der gemessenen Eingangsgrößen E und der unbekannten inneren Prozessparameter (also den Netzparametern) y beschriebenen, Prozessausgangsgrößen $A_{Mod}$ und den tatsächlich gemessenen Ausgangsgrößen $A_P$, so erhält man den so genannten Modellfehler $\varepsilon$ (bzw. eine Modellfehlerfunktion), also die Abweichung der durch das mathematische Modell mit den unbekannten inneren Parametern errechneten Ausgangsgrößen von den tatsächlich gemessenen. Die Aufgabe lautet folglich, die unbekannten inneren Parameter y so zu bestimmen, dass die bei gegebenen Eingangsgrößen E mit dem mathematischen Modell und mit diesen Parametern berechneten Ausgangsgrößen A weitgehend den wirklich gemessenen Ausgangsgrößen entsprechen, also eine sich aus den Modellfehlerfunktionen $\varepsilon$ über den betrachteten Beobachtungszeitraum ergebende Verlustfunktion V minimiert wird.

Üblicherweise werden die Messwerte der Eingangsgrößen E und Ausgangsgrößen A des Prozesses während einer Anregung des Systems zu äquidistanten Zeitpunkten mit einer, an die Dynamik des Prozesses angepassten, Abtastfrequenz abgetastet, A/D konvertiert, gegebenenfalls vorgefiltert und vorzugsweise zur Weiterverarbeitung digital gespeichert. Die oben genannte Modellfehlerfunktion $\varepsilon$ kann somit als Funktion der inneren Prozessparameter y für jeden Messwertsample des Beobachtungszeitraumes bestimmt werden. Im Fall einer Ausgangsgröße ist diese Modellfehlerfunktion $\varepsilon$ eindimensional. Die Verlustfunktion V ist dann beispielsweise durch Bildung der Summe der Quadrate der Modellfehlerfunktion $\varepsilon$ über alle Samples des Beobachtungszeitraumes festgelegt. Die Quadrate der Modellfehlerfunktion $\varepsilon$ können auch bei Bedarf mit Gewichtungsfaktoren gewichtet werden. Damit können besonders vorteilhafte Systemzustände bezüglich der Konditionierung des Schätzverfahrens in ihrer Bedeutung hervorgehoben und weniger vorteilhafte bezüglich ihres Einflusses auf das Schätzergebnis eher unterdrückt werden.

Somit entspricht die Bestimmung der inneren Parameter einem Optimierungsproblem, eben der Bestimmung jener optimalen inneren Parameter y nach einer äußeren Anregung des dynamischen Prozesses, bei denen die, sich aus den Differenzen der berechneten Modellausgangsgrößen $A_{Mod}$ und den tatsächlich gemessenen Ausgangsgrößen $A_P$ ergebende Modellfehlerfunktion $\varepsilon$ über einen Beobachtungszeitraum zur Bestimmung einer Verlustfunktion V benützt wird und diese Verlustfunktion V als Funktion der inneren Parameter y minimiert wird.

Die oben beschriebene Art der Bestimmung innerer Prozessparameter wird üblicherweise als Blockverarbeitung bezeichnet, da ein ganzer Datenblock zur Bestimmung der Prozessparameter verwendet wird.

Eine andere Möglichkeit der Parameterbestimmung deterministischer parametrischer Prozessmodelle ergibt sich durch die Anwendung rekursiver Parameterschätzverfahren. Bei diesen Verfahren werden die messbaren (äußeren) Größen, also die Eingangs- und Ausgangsgrößen des Prozesses zu äquidistanten Zeitpunkten abgetastet und gemessen und die zum (k+1)-ten Zeitpunkt ermittelten Schätzgrößen unter Berücksichtigung der zum (k+1)-ten Zeitpunkt gemessenen Eingangs- und Ausgangsgrößen und den zum (k)-ten Zeitpunkt ermittelten Schätzgrößen, also rekursiv, bestimmt. Da diese rekursive Art der Bestimmung der inneren Prozessparameter gegenüber der so genannten Blockverarbeitung einen normalerweise höheren Rechenaufwand bedingt, werden die auf der Grundlage der Blockverarbeitung beruhenden Algorithmen für diese Art der Problemstellung bevorzugt. Es sei jedoch erwähnt, dass auch diese rekursiven Methoden qualitativ vergleichbare Schätzergebnisse liefern können und folglich ebenfalls verwendet werden könnten.

Wie der einschlägigen Literatur zu entnehmen ist, existieren eine Fülle von bekannten Lösungsansätzen zur Parameterbestimmung von solchen deterministischen parametrischen Prozessen. Alle diese Methoden haben gemein, dass während einer Anregung des Prozesses die Messwerte der messbaren äußeren Größen des Prozesses, also Eingangs- und Ausgangsgrößen, zu meist zeitlich äquidistanten Zeitpunkten mit einer bezüglich der Prozessdynamik geeignet gewählten Abtastfrequenz abgetastet und mit einem oder mehreren Analog/Digitalwandlern in digitale Werte umgeformt sowie bei Bedarf gefiltert werden und diese digitalen Messwertsamples entweder rekursiv oder blockweise in einem Algorithmus zur Bestimmung der Prozessparameter weiterverarbeitet werden.

Die Grundlage aller Methoden zur Bestimmung der Prozessparameter ist üblicherweise ein deterministisches parametrisches Prozessmodell, bei dem ein formelmäßiger Zusammenhang zwischen den messbaren Eingangs- und Ausgangsgrößen des Prozesses mit den Prozessparametern als unbekannte Variable, gegebenenfalls durch zusätzliche Berücksichtigung von Rauschquellen, hergeleitet wird. Die Digitalwerte der Ausgangsgrößen des Modells werden während einer Anregung des Systems (Prozesses) aus den Messwertsamples der messbaren (und gegebenenfalls vorgefilterten) Eingangsgrößen und den, von den inneren Prozessparametern als unbekannte Variable abhängigen, Gleichungen des Prozessmodells bestimmt. Durch Bildung der Differenz zwischen den Ausgangsgrößen des Modells und den tatsächlich durch Messwertabtastung gewonnenen (und gegebenenfalls vorgefilterten) Ausgangsgrößen kann für jeden Sample die Modellfehlerfunktion als Funktion der inneren Prozessparameter bestimmt werden. Aufgrund der Definition einer Verlustfunktion, beispielsweise der Summe der Quadrate der Modellfehlerfunktion über alle Samples des Beobachtungszeitraumes, kann dann diese Verlustfunktion als Funktion der inneren Parameter aufgefasst werden und die optimalen inneren Parameter im Sinne eines Optimierungsproblems derart bestimmt werden, dass die Verlustfunktion für diesen optimalen Parametersatz minimal wird (Blockverarbeitung), oder durch Verwendung der im (k)-ten Sample ermittelten Parameter und der im (k+1)-ten Sample abgetasteten, A/D konvertierten und gegebenenfalls gefilterten Messwertsamples der Eingangs- und Ausgangsgrößen des Prozesses die inneren Parameter für den (k+1)-ten Sample im Sinne der Minimierung einer Verlustfunktion bestimmt werden (rekursiver Algorithmus).

Nachfolgend wird beispielhaft und ohne Einschränkung ein mögliches Verfahren zur Bestimmung der Netzparameter im Zeitbereich beschrieben. Aus den obigen Ausführungen ist jedoch klar, dass es daneben noch eine Fülle weiterer geeigneter Verfahren, insbesondere auch Verfahren im Frequenzbereich, gibt, die ebenfalls zur Anwendung kommen könnten.

Die oben dargestellte grundsätzliche Methode zur Bestimmung der inneren Prozessparameter soll nun anwendungsbezogen auf das Problem der Bestimmung der Netzparameter des Nullsystems eines sternpunktkompensierten Netzes durch beispielhafte Anwendung eines einfachen Verfahrens vorgeführt werden. Wie bereits oben erwähnt lassen sich damit aber analog natürlich auch die Parameter einzelner Leitungsabschnitte oder -abzweige bestimmen, was aufgrund der Analogie hier aber nicht im Detail beschrieben wird. Bezug nehmend auf die obigen Gleichungen des Prozessmodells wird beispielhaft und ohne Einschränkung ein Algorithmus vorgestellt, der als Messgrößen die Messwerte des gefilterten Nullstromes $I_0(t)$ und der gefilterten Sternpunkt-Erdspannung $U_{ne}(t)$ verwendet.

Die Rücktransformation der obigen Gleichungen in den Zeitbereich zeigt, dass sich ohne Berücksichtigung der Anfangsbedingungen das zeitliche Signal des gefilterten Nullstromsignals im Prozessmodell als Linearkombination vom Zeitsignal des gefilterten Sternpunkt-Erdspannungssignals sowie dessen zeitlicher Ableitung und dessen Zeitintegrales beschreiben lässt, also:

$$I_{0MODELL}^{F}(t) - \left[U_{ne}^{F}(t)\right]G_0 - \left[dU_{ne}^{F}(t)/dt\right]C_0 - \left[\int_{0}^{t}U_{ne}^{F}(\tau).d\tau\right].(1/L_1) = 0.$$

Es sei an dieser Stelle erwähnt, dass die Struktur dieser Gleichung auch erhalten bleibt, wenn man die in der obigen Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.

Wird nun der Modellfehler $\varepsilon(t)$ derart definiert, dass $\varepsilon(t) = \left(I_0^F(t) - I_{0MODELL}^F(t)\right)$, dann folgt für die Modellfehlergleichung für den Zeitpunkt t als Funktion des tatsächlich gemessenen und gefilterten Messsignals des Nullstromes $I_0^F(t)$ sowie des gemessenen und gefilterten Messsignals der Sternpunkt-Erdspannung $U_{ne}(t)$ und dessen zeitlicher Ableitung sowie dessen Integrales bezüglich der Zeit:

$$I_0^F(t) - \left[U_{ne}^F(t)\right]G_0 - \left[dU_{ne}^F(t)/dt\right]C_0 - \left[\int_0^t U_{ne}^F(\tau).d\tau\right].(1/L_1) = \varepsilon(t).$$

Diese Beziehung bildet die Grundlage für ein Parameterschätzverfahren, das wie folgt ablaufen kann:

1) Sind durch geeignete Messeinrichtungen sowohl geeignete Messwerte vom, die Erdschlusslöschspule durchfließenden, Nullstrom $I_0$(t) als auch von der Sternpunkt-Erdspannung $U_{ne}$(t) verfügbar, so können deren Messwerte zu zeitlich äquidistanten Zeitpunkten mit einer an die Systemdynamik angepassten Abtastfrequenz abgetastet werden. Deren abgetastete und nachfolgend mit einem A/D Konverter digitalisierte Werte zum (n)-ten Abtastzeitpunkt werden mit $I_0$(n) und $U_{ne}$(n) bezeichnet. Die Messwertabtastung erfolgt zumindest während der Injektion nicht netzfrequenter Signale ins Nullsystem, vorzugsweise aber kontinuierlich.

2) Digitale Filterung der Folgen von $I_0$(n) und $U_{ne}$(n) mithilfe der bereits beschriebenen, für beide Messwertfolgen identischen, Sperrfilterblöcke zur Ausfilterung der netzfrequenten Grundwellenanteile sowie der Oberwellenanteile mit jenen Frequenzen, die den ganzzahlig ungeradzahligen Vielfachen der Netzfrequenz entsprechen oder Anwendung des Superpositionsprinzips zur Elimination der durch den Unsymmetriestrom verursachten Signalanteile aus den obigen Messwertfolgen, zumindest während der Injektionszeit, vorzugsweise aber kontinuierlich. Die Signalwertefolgen der gefilterten Größen werden mit $I_0^F(n)$ und $U_{ne}^F(n)$ bezeichnet. Es sei noch erwähnt, dass die beiden identischen Filterblöcke bei Bedarf noch um bandbreitenbegrenzende Hoch- und Tiefpassfilter erweitert werden könnten.

3) Zu oder vor Beginn des Injektionsvorganges wird bei n = 0 mit dem blockverarbeitenden Algorithmus begonnen und die gefilterten Signale für den jeweils (n)-ten Signalwert mit $f(n) = I_0^F(n)$ und $f_1(n) = U_{ne}^F(n)$ bezeichnet.

4) Numerische Berechnung der Signalwertefolge der ersten Ableitung bezüglich der Zeit von der Signalwertefolge $f_1(n)$ mithilfe der Bilineartransformation oder anderer bekannter numerischer Differentiationsmethoden für Abtastwertefolgen. Bezeichnung der entstehenden, der ersten Ableitung der Abtastwertefolge von $f_1$(n) bezüglich der Zeit entsprechenden, Abtastwertefolge durch $f_2(n)$.

5) Numerische Berechnung der Signalwertefolge des Integrales bezüglich der Zeit von der Signalwertefolge $f_1(n)$ mithilfe der Bilineartransformation oder anderer numerischer Integrationsmethoden für Abtastwertefolgen, beispielsweise nach der Simpsonformel oder der Trapezregel. Bezeichnung der entstehenden, dem Integral bezüglich des Zeitintervalls von der 0-ten bis zur (n)-ten Abtastung der Abtastwertefolge von $f_1(n)$ entsprechenden, Abtastwertefolge durch $f_3(n)$. Der Startwert $f_3(0)$ ist gleich Null zu setzen.

6) Entsprechend den obigen Gleichungen ergibt sich somit für den Modellfehler zum (n)-ten Abtastzeitpunkt folgende Gleichung für alle zwischen Null und N liegenden ganzzahligen Indizes n:

$$f(n) - f_1(n).x_1 - f_2(n).x_2 - f_3(n).x_3 = \varepsilon(n) \quad \forall\, n \in \{0,1,2,...,N\} \quad .$$

Die unbekannten inneren Prozessparameter werden dabei durch die Variablen $x_1$, $x_2$ und $x_3$ repräsentiert.

7) Berechnung der so genannten inneren Produkte gemäß den folgenden Formeln. Die jeweiligen Summen sind über (N+1) Abtastungen zu bilden. Idealerweise wird N so gewählt, dass die Anzahl der vom Algorithmus benützten und bewerteten Abtastungen den gesamten Injektionsvorgang zeitlich gesehen überdeckt. Vor oder zu Beginn des Injektionsvorganges wird mit n=0 gestartet.

$$c_{kj} = \sum_{n=0}^{N} f_k(n) \cdot f_j(n) \qquad \forall\, k, j \in \{1,2,3\}$$

und

$$b_k = \sum_{n=0}^{N} f(n) \cdot f_k(n) \qquad \forall\, k \in \{1,2,3\}$$

8) Die inneren Produkte $c_{kj}$ sind nun als Elemente einer (3x3) Matrix $\underline{\underline{C}}$ und die inneren Produkte $b_k$ sind als (k)-te Koeffizienten eines Vektors $b$ aufzufassen. Die Gleichung $\underline{\underline{C}} \cdot \underline{x} = \underline{b}$ beschreibt somit ein lineares Gleichungssystem 3.Ordnung, dessen Lösungsvektor $\underline{x}$ jene Netzparameter repräsentiert, bei denen die Verlustfunktion, also in diesem Fall die Summe der Modellfehlerquadrate über den Beobachtungszeitraum, der idealer Weise den Injektionszeitraum überdeckt, minimiert wird. Die Lösung des linearen Gleichungssystems zur Bestimmung des Lösungsvektors kann mit jedem bekannten Verfahren zur Lösung linearer Gleichungssysteme durchgeführt werden. Durch einfache, hier nicht dargestellte, Gewichtung der Modellfehlerquadrate kann der Algorithmus bei Bedarf erweitert werden. Die Komponenten $x_1$, $x_2$ und $x_3$ des Lösungsvektors entsprechen dabei den, bezüglich der Verlustfunktion optimalen, Netzparametern $G_0$, $C_0$ und $(1/L_1)$, die damit bestimmt sind. Aus den Parametern können dann zusammen mit anderen Größen natürlich weitere Parameter oder Kennwerte des Netzes, wie z.B. der Unsymmetriestrom $i_v$, der Wattreststrom, der Spulenresonanzstrom, etc., berechnet werden.

Eine vorteilhafte zweite Ausführungsvariante ergibt sich durch die Verwendung des, mithilfe eines Injektionsmodelles aus einem messbaren Injektionssignal rekonstruierten, Injektionsstromsignales $I_{inj}(t)$ und der Messwerte des Nullstromes, also des Löschspulenstromes, $I_0(t)$ als Eingangsgrößen für die Durchführung eines Verfahrens zur Bestimmung der Netzparameter $G_0$, $C_0$ und $L_1$. Die grundlegende Gleichung des Prozessmodells mit diesen Eingangsgrößen wurde oben bereits erläutert. Der Algorithmus verwendet als Signalgrößen die Messwerte des mithilfe oben genannter Sperrfilter oder der Superpositionsmethode gefilterten Nullstroms $I_0^F(t)$ und den durch Verwendung der Zusammenhänge des Injektionsmodells rekonstruierten und nachfolgend mit oben genannten Sperrfiltern oder der Superpositionsmethode gefilterten Injektionsstrom $I_{inj}^F(t)$. Daraus folgt mit $H(s) = I_0^F(s) . G_1(s)$ und $F(s) = I_{inj}^F(s) - I_0^F(s)$ und Rücktransformation in den Zeitbereich

$$H_{MODELL}(t) - \left[ F(t) \right] . (G_0 . L) - \left[ dF(t)/dt \right] . (C_0 . L) - \left[ \int_0^t F(\tau) . d\tau \right] . (L/L_1) = 0.$$

Es sei an dieser Stelle erwähnt, dass die Struktur dieser Gleichung auch erhalten bleibt, wenn man die in der Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.

Durch Vergleich dieser Beziehung mit der grundlegenden Beziehung des oben beschriebenen Verfahrens ist klar die Analogie dieser beiden Methoden zu erkennen. Es wird daher darauf verzichtet, diese zweite Ausführungsvariante zur Bestimmung der Netzparameter nochmals detailliert darzulegen, da die Verfahrensschritte analog zum oben beschriebenen Verfahren durchzuführen sind. Das Signal H(t) kann dabei als Ausgangsgröße des Übertragungsgliedes

$G_1(s)$ aufgefasst werden, dessen Eingangssignal dem gefilterten Nullstromsignal $I_0^F(t)$ entspricht. Die Koeffizienten des Übertragungsgliedes $G_1(s)$, nämlich $G_n$ und $L$, sind aufgrund der Kenntnis der Eisenverluste und der Erdschlusslöschspuleninduktivität bekannt. Somit können auch für diese Ausführungsvariante die in der zugrunde liegenden Gleichung enthaltenen Netzparameter $G_0$, $C_0$ und $L_1$ eindeutig bestimmt werden, da die in den Schätzgrößen enthaltene Spuleninduktivität L der Erdschlusslöschspule für alle Ausführungsformen der Erdschlusslöschspule als bekannt vorausgesetzt werden kann.

Aus dem weiter oben angegebenen Zusammenhang zwischen Verlagerungsspannung $U_{ne}$ und dem Injektionsstromsignal $I_{inj}$ erhält man durch Rücktransformation in den Zeitbereich

$$I_{injMODELL}^F(t) - \left[U_{ne}^F(t)\right]G - \left[dU_{ne}^F(t)/dt\right]C_0 - \left[\int_0^t U_{ne}^F(\tau).d\tau\right].(\frac{1}{L'}) = 0.$$

Diese Beziehung zeigt, dass sich das zeitliche Signal des gefilterten Injektionsstromsignals $I_{inj}$ im Prozessmodell ohne Berücksichtigung der Anfangsbedingungen als Linearkombination vom Zeitsignal des gefilterten Sternpunkt-Erdspannungssignals $U_{ne}$ sowie dessen zeitlicher Ableitung und dessen Zeitintegrals beschreiben lässt. Wird nun der Modellfehler $\varepsilon(t)$ wie gehabt definiert, $\varepsilon(t) = (I_{inj}^F(t) - I_{injMODELL}^F(t))$, folgt für die Modellfehlergleichung für den Zeitpunkt t als Funktion des, durch ein Injektionsmodell aus einem tatsächlich gemessenen Injektionssignal rekonstruierten und nachfolgend gefilterten Signals des Injektionsstromes $I_{inj}^F(t)$, sowie des gemessenen und gefilterten Messsignals der Sternpunkt-Erdspannung $U_{ne}^F(t)$ und dessen zeitlicher Ableitung, sowie dessen Zeitintegrals

$$I_{inj}^F(t) - \left[U_{ne}^F(t)\right]G - \left[dU_{ne}^F(t)/dt\right]C_0 - \left[\int_0^t U_{ne}^F(\tau).d\tau\right].(\frac{1}{L'}) = \varepsilon(t).$$

Daraus können wieder in Analogie zu oben, die Parameter ermittelt werden.

Es sei an dieser Stelle wieder erwähnt, dass die Struktur dieser Gleichung auch erhalten bleibt, wenn man die in der Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.

Aus dieser Beziehung kann nun auch eine besonders vorteilhafte Vereinfachung hergeleitet werden. Wird das Injektionssignal impulsartig eingebracht und sei der Zeitpunkt $t_1 > 0$ derart gewählt, dass $I_{inj}^F(t) = 0$ für t≥$t_1$, man betrachtet also die Zeitspanne nachdem der Impuls eingebracht wurde, dann folgt daraus durch Differenzenbildung für alle t≥$t_1$ ein funktionaler Zusammenhang bezüglich einer einzigen Größe, hier der Verlagerungsspannung $U_{ne}$, der Form

$$\left[U_{ne}^F(t) - U_{ne}^F(t_1)\right]G + \left[dU_{ne}^F(t)/dt - dU_{ne}^F(t_1)/dt\right]C_0 + \left[\int_{t_1}^t U_{ne}^F(\tau).d\tau\right].(\frac{1}{L'}) = -\varepsilon(t).$$

Es sei an dieser Stelle wieder erwähnt, dass die Struktur dieser Gleichung auch erhalten bleibt, wenn man die in der Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.

Dividiert man diese Gleichung ohne Beschränkung der Allgemeinheit durch $C_0$, dann erhält man mit

$$f(t) = \left[ dU_{ne}^F(t_1)/dt - dU_{ne}^F(t)/dt \right],$$

$$f_1(t) = \left[ U_{ne}^F(t) - U_{ne}^F(t_1) \right],$$

$$f_2(t) = \left[ \int_{t_1}^{t} U_{ne}^F(\tau).d\tau \right],$$

$$x_1 = (G/C_0)$$

und

$$x_2 = \left( \frac{1}{L'.C_0} \right)$$

die Gleichung

$$f(t) - f_1(t).x_1 - f_2(t).x_2 = \varepsilon(t) \quad \forall \, t > t_1 \, .$$

Durch zeitlich äquidistante Abtastung des Messsignals der Sternpunkt-Erdspannung $U_{ne}$ und der Durchführung geeigneter numerischer Methoden zur Berechnung dessen zeitlicher Ableitung sowie dessen Zeitintegrals in der bereits beschriebenen Weise erhält man weiter $f(n)-f_1(n).x_1-f_2(n).x_2 = \varepsilon(n) \; \forall \; n \in \{1,2,...,N\}$, wobei der Startzeitpunkt, also der Zeitpunkt des ersten Samples, größer oder gleich $t_1$ zu wählen ist. Durch Berechnung von

$$c_{kj} = \sum_{n=1}^{N} f_k(n) \cdot f_j(n) \qquad \forall \, k,j \in \{1,2\}$$

und

$$b_k = \sum_{n=1}^{N} f(n) \cdot f_k(n) \qquad \forall \, k \in \{1,2\}$$

erhält man wieder die Koeffizienten eines linearen Gleichungssystems, wobei die inneren

Produkte $c_{kj}$ nun als die Elemente einer (2x2) Matrix $\underline{C}$ und die inneren Produkte $b_k$ als (k)-te Koeffizienten eines Vektors $b$ aufzufassen sind. Die Gleichung $\underline{C} \cdot x = \underline{b}$ beschreibt somit ein lineares Gleichungssystem 2. Ordnung, dessen Lösungsvektor $\underline{x}$ jene Parameter repräsentiert, bei denen die Verlustfunktion, also in diesem Fall die Summe der Modellfehlerquadrate über das Bewertungszeitintervall, minimiert wird. Die Lösung des linearen Gleichungssystems zur Bestimmung des Lösungsvektors kann mit jedem bekannten Verfahren zur Lösung linearer Gleichungssysteme durchgeführt werden. Durch einfache, hier nicht dargestellte Gewichtung der Modellfehlerquadrate kann der Algorithmus bei Bedarf erweitert werden. Die Komponenten $x_1$ und $x_2$ des Lösungsvektors entsprechen dabei den, bezüglich der Verlustfunktion optimalen, Parametern $(G/C_0)$ und $\left(\dfrac{1}{L'.C_0}\right)$. Dabei ist speziell der Parameter $\left(\dfrac{1}{L'.C_0}\right)$ von besonderer Bedeutung, da er das Quadrat der Resonanzkreisfrequenz $\omega_{res}$ des Nullsystems des Netzes repräsentiert. Da die impulsartige Injektion auch während des Abstimmvorganges der Erdschlusslöschspule ständig wiederholt werden kann, ist es mit diesem Verfahren möglich, die Erdschlusslöschspule solange abzustimmen, bis die Resonanzkreisfrequenz $\omega_{res}$ den gewünschten Wert annimmt. Bei diesem Verfahren wird als Netzparameter die bei der momentan gegebenen Induktivität der Erdschlusslöschspule ermittelte Resonanzkreisfrequenz $\omega_{res}$ des Nullsystems des Netzes bestimmt, die zur Abstimmung der Erdschlusslöschspule vorteilhaft verwendet werden kann.

Natürlich kann diese wichtige Vereinfachung, nämlich dass das Injektionssignal impulsartig eingebracht und der Startzeitpunkt der Bewertung der Messwerte $t_1>0$ derart gewählt wird, dass für die Zeitpunkte $t>t_1$ der Injektionsstrom $i_{inj}$ bereits als Null angenommen werden kann, auch auf den funktionalen Zusammenhang zwischen den Signalen des Injektionsstromes $i_{inj}$ und des Nullstromes $i_0$ angewandt werden, woraus der Injektionsstrom $i_{inj}$ durch Differenzenbildung wieder eliminiert werden kann. Als Resultat erhält man in analoger Weise zum dargelegten obigen Verfahren wieder ein lineares Gleichungssystem 2. Ordnung, dessen Lösungsvektor als Netzparameter die momentane Resonanzkreisfrequenz $\omega_{res}$ des Nullsystems des Netzes beinhaltet.

Selbstverständlich kann diese wichtige Vereinfachung, nämlich dass das Injektionssignal impulsartig eingebracht und der Startzeitpunkt der Bewertung der Messwerte $t_1>0$ derart gewählt wird, dass für die Zeitpunkte $t>t_1$ der Injektionsstrom $i_{inj}$ bereits als Null angenommen werden kann, auch auf den funktionalen Zusammenhang zwischen den Messsignalen der Sternpunkt-Erdspannung $U_{ne}$ und des Nullstromes $i_0$ angewandt werden, wenn die Anfangsbedingungen in geeigneter Weise, zum Beispiel durch Differenzbildung, berücksichtigt werden. Diese Methode erlaubt dann wieder die Parameterbestimmung in der üblichen Weise, sowohl für das Gesamtnetz als auch für Abzweigparameter.

Ferner kann durch Berechnung der Fouriertransformierten oder der DFT oder FFT für die zu den Zeitpunkten $t>t_1$ ermittelten Messwerte der Sternpunkt-Erdspannung $U_{ne}$ bzw. des Nullstromes $i_0$ die Resonanzkreisfrequenz $\omega_{res}$ ebenfalls einfach bestimmt werden, da klar ist, dass deren Zeitsignale für die Zeitpunkte $t>t_1$ dem Ausschwingvorgang eines durch einen impulsartigen Vorgang angeregten Parallelschwingkreis, also einem exponentiell abklingenden sinusartigen Signal, entsprechen muss. Bildet man nun die Fouriertransformierte, DFT oder FFT für die zu den Zeitpunkten $t>t_1$ ermittelten Messwerte der Sternpunkt-Erdspannung $U_{ne}$ bzw. des Nullstromes $i_0$, so wird die Kreisfrequenz jenes Spektralanteiles, dessen Betrag am größten von allen ist, zumindest näherungsweise der Resonanzkreisfrequenz $\omega_{res}$ entsprechen.

Natürlich existiert eine Fülle weiterer Methoden zur Bestimmung der Resonanzkreisfrequenz $\omega_{res}$, die hier nicht in Ihrer Gesamtheit dargelegt werden können. Entscheidend für diese wichtige Methode ist, dass das Injektionssignal impulsartig eingebracht wird, ein Zeitpunkt $t_1$ festgelegt wird, ab dem angenommen werden kann, dass das Injektionssignal bereits Null bzw. nahezu Null ist und die zu den Zeitpunkten $t>t_1$ ermittelten Messwerte der Sternpunkt-Erdspannung $U_{ne}$ bzw. des Nullstromes $i_0$ einem Verfahren zur Bestimmung der Resonanzkreisfrequenz $\omega_{res}$ im Zeit- oder Frequenzbereich zugeführt werden.

Ebenso könnte man das Parameterschätzverfahren durch Substitution von s mit j$\omega$ und der sich beispielhaft aus dem funktionalen Zusammenhang von Verlagerungsspannung $U_{ne}$ und Nullstrom $i_0$ daraus ergebenden Beziehung

$$I_0^F(j.\omega_n) - U_{ne}^F(j.\omega_n).G_0 - j.U_{ne}^F(j.\omega_n).\omega_n.C_0 - U_{ne}^F(j.\omega_n)\frac{1}{j.\omega_n.L_1} = \varepsilon(\omega_n)$$

im Frequenzbereich durchführen. Dieses Verfahren zur Bestimmung der Netzparameter arbeitet nun mit den diskreten Spektren der diskreten Fourier-Transformation (DFT oder FFT) von den, in den beschriebenen Verfahren benützten, Abtastwertefolgen. Es lässt sich auch zeigen, dass sich die Methoden im Zeitbereich und im Frequenzbereich einander aufgrund der auf die Modellfehlerfunktion angewandten Parsevalschen Gleichung entsprechen und daher auch gleichwertige Ergebnisse erwarten lassen.

Vorteilhafterweise werden die Messwerte bzw. deren Abtastwertefolgen auch bei diesen Frequenzbereichsverfahren durch die beschriebenen Sperrfilterblöcke oder die beschriebene Superpositionsmethode in gleicher Weise wie bei den Zeitbereichsverfahren vorgefiltert, da dadurch sichergestellt wird, dass die Abtastwertefolgen dieser gefilterten Signale, die ja nachfolgend einer DFT oder FFT zugeführt werden, sowohl zu Zeitpunkten vor der Injektion als auch zu Zeitpunkten kurz nach der Beendigung der Injektion Null bzw. fast Null sind, sofern die Filterung der Signale mithilfe der beschriebenen Sperrfilterblöcke kontinuierlich durchgeführt wird oder zumindest einige Zeit vor dem Injektionsstart damit begonnen wurde oder die Superpositionsmethode angewandt wurde. Da zur Berechnung der DFT oder FFT nur jene Abtastwerte der, vom jeweiligen Verfahren benützten, Messwerte verwendet werden, die dem Zeitintervall von kurz vor bis kurz nach der Injektion zugeordnet werden können, kann aufgrund der Filterung der Signale durch die beschriebenen Sperrfilter oder durch die Superpositionsmethode davon ausgegangen werden, dass die Abtastwertefolgen der, dem DFT oder FFT Algorithmus zugeführten, Signale sowohl zu Beginn, also kurz vor dem Injektionsstart, als auch am Ende, also kurz nach dem Ende der Injektion, Null bzw. nahezu Null sind. Durch diese Maßnahme entfällt die Verwendung aufwändiger Fensterfunktionen. Natürlich besteht ohne Beschränkung der Funktionsweise auch die Möglichkeit, auf diese Filterung zu verzichten und die Verlustfunktion im Frequenzbereich so festzulegen, dass die netzfrequenten Signalanteile und auch jene Signalanteile, deren Frequenz ein ganzzahlig ungeradzahliges Vielfaches der Netzfrequenz aufweisen, in geeigneter Weise unterdrückt oder in der Verlustfunktion nicht berücksichtigt werden. Es ist aber zu bedenken, dass die, durch die spektralen Leckeffekte der dann zu verwendenden Fensterfunktionen verursachten, spektralen Verfälschungen bei der Anwendung dieser Methode erhalten bleiben und das Ergebnis in negativer Weise beeinträchtigen können.

Die Verfahren im Zeit- und Frequenzbereich sind als äquivalent anzusehen und liefern qualitativ gleichwertige Ergebnisse.

Es ist noch zu erwähnen, dass sich das oben beschriebene Verfahren natürlich auch für, das Nullsystem sternpunktkompensierter Netze genauer beschreibende, Prozessmodelle höherer Ordnung anwenden lässt, solange sich analog zu den obigen Gleichungen eine lineare Differentialgleichung höherer Ordnung bestimmen lässt, die den Zusammenhang zwischen messbaren Größen, oder aus messbaren Größen ableitbaren Größen, herstellt und zur Bildung einer Modellfehlerfunktion $\varepsilon$ geeignet ist. Dadurch erhöht sich lediglich die Ordnung des resultierenden linearen Gleichungssystems.

Aber selbst für nichtlineare Prozessmodelle existieren geeignete Optimierungsmethoden zur Minimierung der Verlustfunktion. Die Anwendbarkeit dieser Methode (Minimierung einer Verlustfunktion) ist also nicht durch die Struktur oder die Eigenschaften des Prozessmodells eingeschränkt.

Die so bestimmten Parameter des elektrischen Netzes können nun zur Abstimmung der Erdschlusslöschspule verwendet werden. Ein solches Verfahren zur Durchführung der Abstimmung der Erdschlusslöschspule wird beispielhaft entsprechend dem nachfolgend vorgestellten Algorithmus beschrieben:

1) Die Sternpunkt-Erdspannung Une wird kontinuierlich gemessen. Ändert sich der netzfrequente Anteil von $U_{ne}$ und übersteigt die Änderung der Sternpunkt-Erdspannung $U_{ne}$ in Betrag und/oder Phase entweder vordefinierte oder sich aus der kontinuierlichen Messung der Sternpunkt-Erdspannung ergebende Schwellen, so wird ein Injektionszyklus zusammen mit einem Verfahren zur Bestimmung der Parameter des Nullsystems des sternpunktkompensierten Netzes ausgelöst und bei Schritt 3) fortgesetzt. Als Injektionszyklus ist dabei im Wesentlichen das Einspeisen eines Injektionssignals mit einem, den Bereich von $f_{min}$ bis $f_{max}$ im Wesentlichen überdeckenden Frequenzspektrum, das Messen und Erfassen der während des Injektionsvorganges oder nach dem Abklingen des Injektionssignals zu bestimmenden Größen und gegebenenfalls der nachfolgenden Anwendung eines Verfahrens zur Bestimmung mindestens eines Parameters des Nullsystems zu verstehen.

2) Zusätzlich zur Auslösung durch die Änderung des netzfrequenten Anteiles der Sterpunkt-Erdspannung $U_{ne}$ wird in periodischen Zeitabständen ein Injektionszyklus zusammen mit einem Verfahren zur Bestimmung mindestens eines Parameters des Nullsystems des sternpunktkompensierten Netzes ausgelöst und bei Schritt 3) fortgesetzt.

3) Durchführung des Injektionszyklus zusammen mit einem Verfahren zur Bestimmung mindestens einem der wesentlichen Parameter des Nullsystems des Netzes, entweder im Zeitbereich oder im Frequenzbereich, z.B. wie oben beschrieben.

4) Berechnung der zur Einhaltung der Resonanzbedingung notwendigen Erdschlusslöschspuleninduktivität $L_{soll}$ als Funktion der ermittelten Parameter des Nullsystems des Netzes unter Berücksichtigung einer eventuell vom Anwender vorgegebenen Verstimmung.

5) Vergleich der berechneten Erdschlusslöschspuleninduktivität $L_{soll}$ mit der momentan gegebenen Erdschlusslöschspuleninduktivität $L_{ist}$. Liegt der Absolutwert der Differenz von ($L_{soll} - L_{ist}$) unter einer vom Anwender vorgegebenen oder durch $L_{soll}$ und/oder $L_{ist}$ bestimmten Toleranzschwelle, so kann bei Schritt 1) bzw. Schritt 2) fortgefahren und auf eine, sich durch Änderung des netzfrequenten Anteiles der Sternpunkt-Erdspannung $U_{ne}$ oder durch Ablauf der periodischen Vorwahlzeit ergebende, Auslösung eines unter Schritt 3) beschriebenen Injektionsvorganges gewartet werden.

Liegt der Absolutwert der Differenz von ($L_{soll}$ -$L_{ist}$) über dieser vom Anwender vorgegebenen oder durch $L_{soll}$ und/oder $L_{ist}$ bestimmten Toleranzschwelle, so wird die Erdschlusslöschspule in hinlänglich bekannter Weise auf die durch $L_{soll}$ vorgegebene Induktivität abgestimmt. Dies geschieht z.B. bei sogenannten Tauchkernspulen durch Verstellung des Tauchkernes auf eine Position, die aufgrund einer hinterlegten Kennlinie ermittelt wird. Diese Kennlinie beschreibt den Zusammenhang der Spuleninduktivität als Funktion von der Tauchkernstellung. Bei in Stufen schaltbaren Erdschlusslöschspulen ist jene Kombination der Schalterstellungen zu wählen, bei der die, sich aus der Schalterstellung ergebende, Gesamtinduktivität der Erdschlusslöschspule der berechneten Induktivität $L_{soll}$ am nächsten kommt. Dabei sind gegebenenfalls Nebenbedingungen zu beachten. Beispielsweise kann gefordert sein, dass die durch eine Kombination von Schalterstellungen sich gegebene Gesamtinduktivität zwar $L_{soll}$ am nächsten sein soll, aber immer größer oder höchstens gleich $L_{soll}$ sein darf, usw.

6) Nach dem Abstimmen der Erdschlusslöschspule auf $L_{soll}$ wird mit einem der Schritte 1) bis 3) fortgefahren.

Wird eine jener oben beschriebenen Methoden angewandt, bei der das Injektionssignal impulsartig eingebracht und als wichtiger Netzparameter die bei der momentan gegebenen Induktivität der Erdschlusslöschspule ermittelte Resonanzkreisfrequenz $\omega_{res}$ des Nullsystems des Netzes bestimmt wird, so kann auch die nachfolgende Methode zur Abstimmung der Erdschlusslöschspule vorteilhaft verwendet werden.

1) Entweder wird durch die Änderung des netzfrequenten Anteiles der Sternpunkt-Erdspannung $U_{ne}$ oder in periodischen Zeitabständen ein impulsartiger Injektionszyklus zusammen mit einem Verfahren zur Bestimmung der Parameter des Nullsystems des sternpunktkompensierten Netzes, im Wesentlichen zur Bestimmung der Resonanzkreisfrequenz $\omega_{res}$ ausgelöst und durchgeführt.

2) Liegt die ermittelte Resonanzkreisfrequenz $\omega_{res}$ in einem, um die gewünschte Resonanzkreisfrequenz $\omega_{soll}$ errichteten Toleranzfenster, so bleibt die Abstimmung der Erdschlusslöschspule unverändert und es wird wieder auf eine Auslösung des Injektionszyklus mit nachfolgender Bestimmung der Resonanzkreisfrequenz $\omega_{res}$ gewartet. Diese Auslösung erfolgt entweder durch die Änderung des netzfrequenten Anteiles der Sternpunkt-Erdspannung $U_{ne}$ oder durch Ablauf der vorgegebenen Zeitperiode.

Liegt die ermittelte Resonanzkreisfrequenz außerhalb einem, um die gewünschte Resonanzkreisfrequenz $\omega_{soll}$ errichteten Toleranzfenster, so ist die Erdschlusslöschspule in eine Richtung, abhängig davon, ob die ermittelte Resonanzkreisfrequenz $\omega_{res}$ größer oder kleiner als die gewünschte Resonanzkreisfrequenz $\omega_{soll}$ ist, zu verstimmen. Handelt es sich bei der verwendeten Erdschlusslöschspule um eine Tauchkernspule, so erfolgt deren Induktivitätsänderung während des Verstimmungsvorganges so langsam, dass der oben beschriebene Injektionsvorgang mit nachfolgender Bestimmung der Resonanzkreisfrequenz $\omega_{res}$ während des Verstimmungsvorganges solange wiederholt wird, bis die ermittelte Resonanzkreisfrequenz $\omega_{res}$ im Toleranzfenster liegt und der Verstimmungsvorgang somit abgeschlossen werden kann.

Die bestimmten Netzparameter oder Parameter eines oder mehrerer Leitungsabschnitte und/oder -abzeige können aber auch zur Erkennung und/oder Ortung von Erdfehlern oder zur Erkennung und/oder Lokalisierung von Schalthandlungen im Netz verwendet werden. Ein solches Verfahren wird in der WO 2004/003578 A1 des Anmelders, die Teil der Offenbarung dieser Anmeldung ist, beschrieben. Mit dem darin offenbarten Verfahren kann ein fehlerhafter Leitungsabschnitt oder Leitungsabzweig sehr einfach ermittelt werden, wie nachfolgend kurz umrissen. Springt nämlich der Realteil der Leitungsabzweignulladmittanz $Y(n) = g+C·s$ plötzlich über eine vorwählbare Schwelle oder überschreitet die Differenz vom aktuellen Realteil und dem Wert vergangener Realteile eine andere vorwählbare Schwelle, während der Imaginärteil weitestgehend konstant bleibt, so ist der Leitungsabschnitt bzw. Leitungsabzweig fehlerhaft. Ändert sich hingegen plötzlich der Imaginärteil der Nulladmittanz, also überschreitet z.B. der Absolutbetrag der Differenz vom aktuellen Imaginärteil und von vergangener Imaginärteile der Abschnittsnulladmittanz eine gewisse vorwählbare Schwelle für eine vordefinierte Zeit, während der Realteil weitgehend konstant bleibt, so hat im überwachten Leitungsabschnitt bzw. -abzweig eine Zu- oder Abschaltung von einem oder mehreren Leitungsteilen stattgefunden.

Das nicht netzfrequente Injektionssignal kann in unterschiedlicher Weise in das Nullsystem des Netzes eingebracht werden.

Als erste Möglichkeit bietet sich an, das Injektionssignal in Form einer, mit der Erdschlusslöschspule in Serie geschalteten, Spannungsquelle einzubringen. Dabei wird der aus der Serienschaltung dieser Spannungsquelle und der Erdschlusslöschspule sich ergebende Zweipol einerseits mit dem Sternpunkt des Transformators oder mit dem Sternpunktanschluss eines Sternpunktbildners und andererseits mit Erde verbunden. Natürlich kann dieses Injektionssignal auch über einen einphasigen Transformator eingebracht werden, wobei dabei die erwähnte Spannungsquelle durch die Sekundärseite dieses Transformators zu ersetzen ist und eine Injektionsspannungsquelle mit der Primärseite dieses Transformators verbunden ist.

Als weitere Möglichkeit bietet sich die Einbringung des Injektionssignals in Form einer, zur Erdschlusslöschspule parallelen, Stromquelle an. Dies kann einerseits durch Einbringen eines Injektionsstromes in die Sekundärseite eines Einphasentransformators erfolgen, dessen Primärseite zur Erdschlusslöschspule parallel geschaltet ist oder andererseits über eine eventuell vorhandene Hilfswicklung der Erdschlusslöschspule direkt oder ebenfalls über einen Transformator erfolgen.

Es sei jedoch erwähnt, dass es natürlich vielfältige Möglichkeiten gibt, das Injektionssignal in das Nullsystem des Netzes einzubringen und alle diese Methoden für das nachfolgend dargelegte Verfahren als brauchbar anzusehen sind.

Wenn man bedenkt, dass ein aus der Serienschaltung einer Spannungsquelle mit einer Impedanz bestehender Zweipol sich immer durch einen Zweipol ersetzen lässt, der aus einer Stromquelle parallel zu dieser Impedanz besteht, wird erkennbar, dass unabhängig von der Art der Einbringung des Injektionssignals eine Ersatzschaltung, also ein Injektionsmodell, bestimmt werden kann, durch das die funktionalen Zusammenhänge zwischen einem messbaren äußeren Injektionssignal in Form einer Spannungs- oder Stromquelle und dem modellhaften Injektionsstrom $i_{inj}(t)$ nach Fig.3 herstellbar sind. Diese modellhafte Injektionsstromquelle $i_{inj}(t)$ bildet parallel mit der Spulenimpedanz $X_n$ den Zweipol der Erdschlusslöschspule und entzieht sich aufgrund der Parallelschaltung mit $X_n$ somit der direkten Messung.

Das Injektionsfrequenzspektrum kann natürlich ebenfalls auf verschiedenste Arten erzeugt werden.

Eine Möglichkeit besteht darin, das Frequenzspektrum dadurch abzudecken, indem durch kontinuierliches oder diskretes Verändern der Frequenz des Injektionssignals (z.B. eines Sinussignals) das Frequenzspektrum von $f_{min}$ bis $f_{max}$, vorzugsweise in einem vorgegebenen Zeitraum von einigen Sekunden, generiert wird. Die untere Frequenz $f_{min}$ und die obere Frequenz $f_{max}$ des Frequenzspektrums des Injektionssignals kann durch den Anwender vorteilhaft so gewählt werden, dass für alle möglichen Netztopologien bzw. Schaltzustände des Netzes sowie dem Stellbereich der Löschspule und eventuell im Netz vorhandener Zusatzspulen die sich aus der Resonanzkreisfrequenz $\omega_{res}$ ergebenden Resonanzfrequenz $f_{res}$ bezüglich des Nullsystems des Netzes immer im Intervall $f_{min}$ bis $f_{max}$ enthalten ist. Bei einer diskreten Erhöhung ist es weiters wünschenswert, dass die diskreten Schritte eng genug gewählt werden, um sicher eine Frequenz im Frequenzspektrum enthalten zu haben, die nahe genug an der Resonanzfrequenz $\omega_{res}$ liegt, um eine Anregung mit zumindest annähernd der Resonanzfrequenz $\omega_{res}$ und damit durch die Anregung bei Resonanzfrequenz $\omega_{res}$ große Signalamplituden sicher zu stellen.

Natürlich ist es in einer weiteren Ausführungsvariante auch möglich, die gewünschten Spektralanteile des Injektionsspektrums nicht sequentiell, sondern durch nicht sinusförmige, beispielsweise impulsartige, Injektionssignale gleichzeitig ins Nullsystem des Gesamtnetzes einzubringen. Dazu sollte die Signalform des Injektionssignals so gewählt werden, dass dessen Fouriertransformation weitgehend von Null verschiedene Spektralanteile im Frequenzbereich zwischen den oben definierten Grenzfrequenzen $f_{min}$ und $f_{max}$ beinhaltet, also keine Lücken im Frequenzspektrum enthalten sind. Damit kann ebenfalls sichergestellt werden, dass die Resonanzfrequenz des Nullsystems des Gesamtnetzes vorteilhaft im Injektionsspektrum enthalten ist. Eine mögliche Umsetzung könnte z.B. mittels eines Kondensators erfolgen, der aufgeladen und anschließend über einen geeignet dimensionierten Widerstand entladen wird, wodurch ein impulsartiges Signal erzeugt wird. Der, in der Praxis natürlich nur annähernd erreichbare, Idealfall wäre ein Dirac-Impuls, da dessen Frequenzspektrum bekannter Weise alle Frequenzen gleichmäßig beinhaltet.

Im gewünschten Frequenzbereich zwischen $f_{min}$ bis $f_{max}$, also beispielsweise zwischen 15Hz und 150Hz, sind natürlich unendlich viele Frequenzen enthalten. In der Praxis wird es unmöglich sein, ein Signal zu erzeugen, dass alle Frequenzen dieses Bereichs gleichmäßig abdeckt. Vielmehr wird es so sein, dass ein Injektionssignal gewählt wird, dessen Fouriertransformierte ein möglichst gleichmäßiges Frequenzspektrum und möglichst keine Frequenzen mit Spektralanteil gleich Null beinhaltet. Bei einem diskreten Frequenzspektrum kann dies durch die Wahl ausreichend kleiner diskreter Schritte sichergestellt werden. Beispielsweise kann der Bereich von $f_{min}$ bis $f_{max}$, z.B. von 15Hz bis 150Hz, mit Frequenzinkrementen von 1 Hz durchlaufen werden, wodurch sich für den beispielhaft angegebenen Frequenzbereich 136 diskrete Frequenzen ergeben würden. Wichtig ist nur, dass die durch die Diskretisierung entstehenden Frequenzlücken so klein sind, dass mit Sicherheit bei einer diskreten Frequenz eine Anregung mit zumindest annähernd Resonanzfrequenz erfolgt.

Selbstverständlich liefern auch Mischformen des ersten und zweiten beschriebenen Injektionsverfahrens zufrieden stellende Ergebnisse. Entscheidend ist dabei nur, dass die Fouriertransformierte des Injektionssignales, vorzugsweise über die gesamte Injektionszeit betrachtet, ein das Frequenzintervall $f_{min}$ bis $f_{max}$ weitgehend überdeckendes Frequenzspektrum liefert.

**Patentansprüche**

1. Verfahren zur Bestimmung mindestens eines Parameters des Nullsystems eines elektrischen Versorgungsnetzes (1), vorzugsweise mit induktiv oder über ohmschen Widerstand geerdetem oder isoliertem Netzsternpunkt (4), und/oder eines Parameters eines Leitungsabschnittes bzw. Leitungsabzweiges des elektrischen Versorgungsnetzes (1), insbesondere die Nulladmittanz ($Y_0$) bzw. (Y), die Phasensumme der Leitwerte der ohmschen Ableitungen ($G_0$) bzw. (g), die Phasensumme der Ableitkapazitäten ($C_0$) bzw. (C) und/oder die Resonanzkreisfrequenz ($\omega_{res}$) des Nullsystems des Versorgungsnetzes (1), wobei in den Netzsternpunkt (4) oder in das Nullsystem des elektrischen Versorgungsnetzes (1) zumindest zeitweise ein Injektionssignal ($i_{inj}$) eingespeist wird und mit dem Injektionssignal ($i_{inj}$) ein Frequenzspektrum eingespeist wird, **dadurch gekennzeichnet, dass** das Frequenzspektrum des Injektionssignals ($i_{inj}$) den Bereich zwischen einer wählbaren minimalen Frequenz ($f_{min}$) und einer wählbaren maximalen Frequenz ($f_{max}$) im Wesentlichen lückenlos abdeckt und im Frequenzspektrum die Resonanzfrequenz ($\omega_{res}$) des Nullsystems des elektrischen Versorgungsnetzes (1) enthalten ist und dass zumindest ein Parameter aus einem funktionalen Zusammenhang in Form einer Gleichung mit dem Parameter und den Größen Nullstrom ($i_0$) und Injektionssignal ($i_{inj}$) oder Verlagerungsspannung ($U_{ne}$) und Injektionssignal ($i_{inj}$) bezüglich des eingespeisten Frequenzspektrums durch ein Verfahren im Zeitbereich oder Frequenzbereich ermittelt wird.

2. Verfahren nach Anspruch 1, **dadurch gekennzeichnet, dass** als Injektionssignal ein Signal gewählt wird, vorzugsweise ein impulsförmiges Signal, das zwischen der minimalen Frequenz ($f_{min}$) und der maximalen Frequenz ($f_{max}$) von Null verschiedene Spektralanteile beinhaltet und damit das Frequenzspektrum zumindest teilweise erzeugt wird.

3. Verfahren nach Anspruch 1 oder 2, **dadurch gekennzeichnet, dass** die netzfrequenten Signalanteile und Signalanteile mit Frequenzen, die einem ganzzahlig ungeradzahligem Vielfachen der Netzfrequenz entsprechen, aus dem Frequenzspektrum der gemessenen Größen herausgefiltert werden oder durch Subtraktion der vor dem Start des Injektionsvorganges als Funktion der Zeit gemessenen und bezüglich der Netzperiode für die Zeiten nach dem Injektionsvorgang periodisch fortgesetzten Größen von den gemessenen Größen aus diesen Größen entfernt werden.

4. Verfahren nach einem der Ansprüche 1 bis 3, **dadurch gekennzeichnet, dass** die Parameter mittels eines Parameterschätzverfahrens ermittelt werden.

5. Verfahren nach einem der Ansprüche 1 bis 4, **dadurch gekennzeichnet, dass** das elektrische Versorgungsnetz und/oder ein Leitungsabschnitt bzw. Leitungsabzweig durch ein mathematisches Modell beschrieben wird, bei dem die Modellausgangsgrößen ($A_{Mod}$) als Funktion der messbaren Eingangsgrößen E und der Parameter beschrieben werden.

6. Verfahren nach Anspruch 5, **dadurch gekennzeichnet, dass** eine Modellfehlerfunktion ($\varepsilon$) als Differenz aus gemessenen Ausgangsgrößen ($A_P$) und Modellausgangsgrößen ($A_{Mod}$) und daraus eine Verlustfunktion (V), beispielsweise in Form der Summe der Quadrate der Modellfehlerfunktion ($\varepsilon$) über den Beobachtungszeitraum, ermittelt wird, die zur Bestimmung der Parameter derart optimiert wird, dass die Verlustfunktion (V) minimal wird.

7. Verfahren nach einem der Ansprüche 1 bis 6, **dadurch gekennzeichnet, dass** die gemessenen Signale Nullstrom ($i_0(t)$) oder Verlagerungsspannung ($U_{ne}(t)$) und Injektionssignal ($I_{inj}(t)$) abgetastet und digitalisiert und gegebenenfalls deren netzfrequente Signalanteile und gegebenenfalls jene Signalanteile mit Frequenzen, die einem ganzzahlig ungeradzahligem Vielfachen der Netzfrequenz entsprechen, entfernt werden und die daraus entstehenden Signalwertefolgen $i_0(n)$ oder und $I_{inj}(n)$ gespeichert werden.

8. Verfahren nach Anspruch 7, **dadurch gekennzeichnet, dass** aus den Signalwertefolgen $i_0(n)$ oder und $I_{inj}(n)$, oder äquivalent aus deren Zeitintegralen beliebiger Ordnung oder deren Ableitungen bezüglich der Zeit beliebiger Ordnung, eine Modellfehlerfunktion $\varepsilon(n)$ als

$$f(n) - f_1(n) \cdot x_1 - f_2(n) \cdot x_2 - f_3(n) \cdot x_3 = \varepsilon(n) \quad \forall\, n \in \{0,1,2,...,N\},$$

mit f(n), $f_1(n)$, $f_2(n)$ und $f_3(n)$ als Signalwertefolge der Messwerte oder deren äquivalenten Größen bezüglich der Zeit von Nullstrom ($i_0(t)$) oder Verlagerungsspannung ($U_{ne}(t)$) und Injektionssignal ($I_{inj}(t)$), Signalwertefolge der ersten Ableitung bezüglich der Zeit oder deren äquivalenten Größen der Messwerte Nullstrom ($i_0(t)$) oder Verlagerungsspannung ($U_{ne}(t)$) und Injektionssignal ($I_{inj}(t)$), Signalwertefolge des Integrals bezüglich der Zeit oder deren äquivalenten Größen der Messwerte Nullstrom ($i_0(t)$) oder Verlagerungsspannung ($U_{ne}(t)$) und Injektionssignal ($I_{inj}(t)$) und $x_1$, $x_2$ und $x_3$ als Parameter des elektrischen Versorgungsnetzes oder Leitungsabschnittes bzw. Leitungsabzweiges davon, gebildet wird.

9. Verfahren nach Anspruch 8, **dadurch gekennzeichnet, dass** ein lineares Gleichungs-*N* system $\underline{C} \cdot \underline{x} = \underline{b}$ gebildet wird, mit einer Matrix $\underline{C}$ mit Elementen $c_{kj} = \sum_{n=0}^{N} f_k(n) \cdot f_j(n), \quad N \, \forall k, j \in \{1,2,3\}$, einem Vektor $\underline{b}$ mit Elementen

$$b_k = \sum_{n=0}^{N} f(n) \cdot f_k(n), \quad \forall k \in \{1,2,3\}$$ und einem die gesuchten Parameter enthaltenden Lösungsvektor $\underline{x}$, das mit hinlänglich bekannten Methoden zur Lösung von linearen Gleichungssystemen gelöst wird.

10. Verfahren nach einem der Ansprüche 1 bis 9, **dadurch gekennzeichnet, dass** die bestimmten Parameter des elektrischen Versorgungsnetzes bzw. eines Leitungsabschnittes bzw. -abzweigs, insbesondere $Y_0$, Y, G, g, $C_0$, C und/oder $\omega_{res}$, zur Erkennung und Ortung von Erdfehlern, Erkennung und Lokalisierung von Schalthandlungen im Versorgungsnetz (1) und/oder zur Abstimmung einer Erdschlusslöschspule verwendet werden.

11. Verfahren nach Anspruch 10, **dadurch gekennzeichnet, dass** ein Erdfehler erkannt und gegebenenfalls angezeigt wird, wenn der Realteil und/oder die Realteiländerung der Nulladmittanz (*Y*) des Versorgungsnetzes (1) oder eines Leitungsabschnittes bzw. - abzweiges für eine vorgegebene Zeitspanne eine vorgegebene Fehlerschwelle überschreitet.

12. Verfahren nach Anspruch 11, **dadurch gekennzeichnet, dass** das Ende eines Fehlerzustandes erkannt und gegebenenfalls angezeigt wird, wenn für den Realteil und/oder die Realteiländerung die vorgegebene Fehlerschwelle für eine vorgegebene Zeitspanne wieder unterschritten wird.

13. Verfahren nach Anspruch 10, **dadurch gekennzeichnet, dass** eine Schalthandlung im Gesamtnetz oder innerhalb eines Leitungsabschnittes bzw. -abzweiges erkannt und gegebenenfalls angezeigt wird, wenn der Imaginärteil bzw. die Imaginärteiländerung der Nulladmittanz des Versorgungsnetzes ($Y_0$) oder eines Leitungsabschnittes bzw. -abzweiges (Y(n)) für eine vorgegebene Zeitspanne eine vorgegebene Fehlerschwelle überschreitet.

14. Verfahren nach Anspruch 10, **dadurch gekennzeichnet, dass** die zur Abstimmung notwendige Erdschlusslöschspuleninduktivität ($L_{soll}$), gegebenenfalls unter Berücksichtigung eines vom Anwender vorgegebenen Verstimmungsgrads, als Funktion der ermittelten Parameter des Nullsystems des elektrischen Versorgungsnetzes (1) zur Einhaltung der Resonanzbedingung ermittelt wird.

15. Verfahren nach Anspruch 14, **dadurch gekennzeichnet, dass** die bestimmte Erdschlusslöschspuleninduktivität ($L_{soll}$) mit der momentan gegebenen Erdschlusslöschspuleninduktivität ($L_{ist}$) verglichen wird und die Erdschlusslöschspule auf die bestimmte Erdschlusslöschspuleninduktivität ($L_{soll}$) abgestimmt wird, falls die Abweichung der bestimmten Erdschlusslöschspuleninduktivität ($L_{soll}$) von der momentan gegebenen Erdschlusslöschspuleninduktivität ($L_{ist}$) eine vorgebbare Toleranzschwelle überschreitet.

16. Vorrichtung zur Bestimmung mindestens eines Parameters des Nullsystems eines elektrischen Versorgungsnetzes (1), vorzugsweise mit induktiv oder über ohmschen Widerstand geerdetem oder isoliertem Netzsternpunkt, und/oder eines Parameters eines Leitungsabschnittes bzw. Leitungsabzweiges des elektrischen Versorgungsnetzes (1), insbesondere die Nulladmittanz ($Y_0$) bzw. (Y), die Phasensumme der Leitwerte der ohmschen Ableitungen ($G_0$) bzw. (g), die Phasensumme der Ableitkapazitäten ($C_0$) bzw. (C) und/oder die Resonanzkreisfrequenz ($\omega_{res}$) des Nullsystems des Versorgungsnetzes (1), mit einer Injektionseinheit zur Einspeisung eines Signals in das Nullsystem des elektrischen Versorgungsnetzes (1), wobei mit der Injektionseinheit ein Injektionssignal ($i_{inj}$) mit einem Frequenzspektrum erzeugbar und in das Nullsystem des Versorgungsnetzes (1) einspeisbar ist, **dadurch gekennzeichnet, dass** das Frequenzspektrum des Injektionssignals ($i_{inj}$) den Bereich zwischen einer wählbaren minimalen Frequenz ($f_{min}$) und einer wählbaren maximalen Frequenz ($f_{max}$) im Wesentlichen lückenlos abdeckt und im Frequenzspektrum des Injektionssignals ($i_{inj}$) die Resonanzfrequenz ($\omega_{res}$) des Nullsystems des elektrischen Versorgungsnetzes enthalten ist, **dass** eine Messeinrichtung vorgesehen ist, mit die Größe Nullstrom $i_0$ oder Verlagerungsspannung $U_{ne}$ und Injektionssignal ($i_{inj}$) bezüglich des eingespeisten Frequenzspektrums messbar ist **und dass** eine Auswerteeinheit vorgesehene ist, mittels der der Parameter aus einem funktionalen Zusammenhang in Form einer Gleichung mit dem Parameter und den gemessenen Größen aus ermittelbar ist.

17. Vorrichtung nach Anspruch 16, **dadurch gekennzeichnet, dass** in der Auswerteeinheit die netzfrequenten Signalanteile und Signalanteile mit Frequenzen, die einem ganzzahlig ungeradzahligem Vielfachen der Netzfrequenz entsprechen aus den gemessenen Größen entfernbar ist.

18. Vorrichtung nach Anspruch 16 oder 17, **dadurch gekennzeichnet, dass** zur Einspeisung des Injektionssignals ($i_{inj}$) eine zu einer Erdschlusslöschspule in Serie geschaltete Spannungsquelle oder eine zu einer Erdschlusslöschspule parallele Stromquelle vorgesehen ist.

19. Vorrichtung nach einem der Ansprüche 16 bis 18, **dadurch gekennzeichnet, dass** mit der Injektionseinheit ein impulsförmiges Injektionssignal ($i_{inj}$) erzeugbar und in das Nullsystem des Versorgungsnetzes (1) einspeisbar ist.

Fig. 1

**Fig. 2**

Erdschluss-Löschspule
mit Injektions Einheit

Netz

**Fig. 3**

Fig. 4

Europäisches
Patentamt

European
Patent Office

Office européen
des brevets

# EUROPÄISCHER RECHERCHENBERICHT

Nummer der Anmeldung

EP 14 17 1234

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 103 07 668 B3 (EDC GMBH [DE]) 13. Januar 2005 (2005-01-13) * Absatz [0018] - Absatz [0022]; Abbildungen 1-3 * * Absatz [0030] - Absatz [0035]; Ansprüche 1, 9 * ----- | 1-19 | INV. G01R31/08 G01R31/11 G01R27/26 G01R27/16 H02H3/00 H02H9/08 |
| X,D | WO 2004/003578 A (ADAPTIVE REGELSYSTEME GESELLSCHAFT MBH; LEIKERMOSER, ALBERT) 8. Januar 2004 (2004-01-08) * Seite 4, Zeile 11 - Seite 11, Zeile 3; Abbildungen 1, 2 * * Seite 13, Zeile 19 - Zeile 29; Ansprüche 1-5 * ----- | 1-19 | |
| X | WO 02/15355 A (ADAPTIVE REGELSYSTEME GESELLSCHAFT M.B.H; LEIKERMOSER, ALBERT) 21. Februar 2002 (2002-02-21) * Ansprüche 1, 11-14; Abbildungen 1, 2 * ----- | 1,16 | |
| X A | US 5 587 662 A (KELLEY ARTHUR W [US] ET AL) 24. Dezember 1996 (1996-12-24) * Spalte 4, Zeile 1 - Zeile 5; Anspruch 1; Abbildungen 1, 4A, 4B * ----- | 16 1-15, 17-19 | RECHERCHIERTE SACHGEBIETE (IPC) G01R |
| A | Heinz Unbehauen: "Regelungstechnik I", 31. März 1989 (1989-03-31), Vieweg Verlag, Braunschweig / Wiesbaden / Deutschland, XP002730699, ISBN: 3-528-53332-3 Bd. 6, Seiten 48-50, * das ganze Dokument * ----- | 19 | |
| A,D | EP 0 595 677 A (ELECTRICITE DE FRANCE SERVICE NATIONAL; ELECTRICITE DE FRANCE) 4. Mai 1994 (1994-05-04) * Zusammenfassung; Anspruch 1; Abbildungen 1-4 * ----- -/-- | 1-19 | |

Der vorliegende Recherchenbericht wurde für alle Patentansprüche erstellt

| Recherchenort | Abschlußdatum der Recherche | Prüfer |
|---|---|---|
| Berlin | 14. Oktober 2014 | Koll, Hermann |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes
   Dokument

EPO FORM 1503 03.82 (P04C03)

Europäisches
Patentamt

European
Patent Office

Office européen
des brevets

# EUROPÄISCHER RECHERCHENBERICHT

**Nummer der Anmeldung**

EP 14 17 1234

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DE 103 07 972 A1 (EDC GMBH [DE]) 9. September 2004 (2004-09-09) * Zusammenfassung; Anspruch 1; Abbildung 1 * * Absatz [0010] * * Absatz [0027] * ----- | 1-19 | |
| A,D | EP 0 235 145 A (WINTER, KLAUS) 9. September 1987 (1987-09-09) * Anspruch 1; Abbildungen 1, 2 * ----- | 1-19 | |
| A,D | DE 100 06 443 A1 (KOELN KLAUS WILHELM [DE] KOELN KLAUS-WILHELM [DE]) 11. Oktober 2001 (2001-10-11) * Ansprüche 1-6; Abbildung 1 * * Absatz [0003] * ----- | 19 | |
| A | EP 0 696 830 A (LICENTIA PATENT-VERWALTUNGS-GMBH) 14. Februar 1996 (1996-02-14) * Anspruch 1; Abbildung 1 * ----- | 19 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Berlin | 14. Oktober 2014 | Koll, Hermann |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 14 17 1234

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-10-2014

| Im Recherchenbericht angeführtes Patentdokument | Datum der Veröffentlichung | Mitglied(er) der Patentfamilie | | Datum der Veröffentlichung |
|---|---|---|---|---|
| DE 10307668 B3 | 13-01-2005 | AT | 500031 A2 | 15-10-2005 |
| | | DE | 10307668 B3 | 13-01-2005 |
| WO 2004003578 A | 08-01-2004 | AT | 413769 B | 15-05-2006 |
| | | AU | 2003238492 A1 | 19-01-2004 |
| | | DE | 50301569 D1 | 08-12-2005 |
| | | EP | 1516193 A1 | 23-03-2005 |
| | | WO | 2004003578 A1 | 08-01-2004 |
| WO 0215355 A | 21-02-2002 | AT | 411937 B | 26-07-2004 |
| | | AU | 1212902 A | 25-02-2002 |
| | | DE | 50107767 D1 | 24-11-2005 |
| | | EP | 1307753 A2 | 07-05-2003 |
| | | HU | 0301630 A2 | 28-08-2003 |
| | | WO | 0215355 A2 | 21-02-2002 |
| US 5587662 A | 24-12-1996 | KEINE | | |
| EP 0595677 A | 04-05-1994 | AT | 196038 T | 15-09-2000 |
| | | DE | 69329326 D1 | 05-10-2000 |
| | | DE | 69329326 T2 | 15-03-2001 |
| | | DK | 0595677 T3 | 02-01-2001 |
| | | EP | 0595677 A1 | 04-05-1994 |
| | | ES | 2149192 T3 | 01-11-2000 |
| | | FI | 951958 A | 01-06-1995 |
| | | FR | 2697341 A1 | 29-04-1994 |
| | | NO | 951569 A | 08-06-1995 |
| | | PT | 595677 E | 31-01-2001 |
| | | US | 5559439 A | 24-09-1996 |
| | | WO | 9410735 A1 | 11-05-1994 |
| DE 10307972 A1 | 09-09-2004 | AT | 500004 A2 | 15-10-2005 |
| | | DE | 10307972 A1 | 09-09-2004 |
| EP 0235145 A | 09-09-1987 | AU | 583868 B2 | 11-05-1989 |
| | | AU | 5093785 A | 18-06-1986 |
| | | BR | 8507285 A | 03-11-1987 |
| | | DE | 3581944 D1 | 04-04-1991 |
| | | EP | 0235145 A1 | 09-09-1987 |
| | | FI | 872188 A | 18-05-1987 |
| | | JP | S62500907 A | 09-04-1987 |
| | | SE | 450675 B | 13-07-1987 |
| | | SU | 1627100 A3 | 07-02-1991 |
| | | US | 4729052 A | 01-03-1988 |
| | | WO | 8603350 A1 | 05-06-1986 |

EPO FORM P0461

Für nähere Einzelheiten zu diesem Anhang : siehe Amtsblatt des Europäischen Patentamts, Nr.12/82

**ANHANG ZUM EUROPÄISCHEN RECHERCHENBERICHT
ÜBER DIE EUROPÄISCHE PATENTANMELDUNG NR.**

EP 14 17 1234

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-10-2014

| Im Recherchenbericht angeführtes Patentdokument | Datum der Veröffentlichung | Mitglied(er) der Patentfamilie | Datum der Veröffentlichung |
|---|---|---|---|
| DE 10006443 A1 | 11-10-2001 | KEINE | |
| EP 0696830 A | 14-02-1996 | DE 4428118 A1<br>EP 0696830 A1 | 15-02-1996<br>14-02-1996 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 235145 B1
- EP 595677 A1
- WO 2004003578 A1
- WO 0215355 A2
- US 5587662 A
- DE 10006443 A1